(19) Europäisches Patentamt
European Patent Office
Office européen des brevets

(11) EP 2 302 454 B1

(12) **EUROPEAN PATENT SPECIFICATION**

(45) Date of publication and mention of the grant of the patent:
**09.01.2013 Bulletin 2013/02**

(51) Int Cl.:
***G03F 7/00*** *(2006.01)* ***G02B 5/20*** *(2006.01)*

(21) Application number: **10178699.4**

(22) Date of filing: **23.09.2010**

(54) **Titanium black dispersion composition and method of producing the same, photosensitive resin composition and method of producing the same, light-shielding color filter and method of producing the same, and solid-state image sensor**

Titanschwarz-Dispersionszusammensetzung und Herstellungsverfahren dafür, lichtempfindliche Harzzusammensetzung und Herstellungsverfahren dafür, lichtabschirmender Farbfilter und Herstellungsverfahren dafür und Feststoff-Bildsensor

Composition se présentant sous la forme d'une dispersion de noir de titane, son procédé de fabrication, composition de résine photosensible et son procédé de fabrication, filtre couleur opaque à la lumière et son procédé de fabrication, et capteur d'image à l'état solide

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **28.09.2009 JP 2009223127**

(43) Date of publication of application:
**30.03.2011 Bulletin 2011/13**

(73) Proprietor: **Fujifilm Corporation**
**Minato-ku**
**Tokyo (JP)**

(72) Inventor: **Kubota, Makoto**
**Shizuoka-ken (JP)**

(74) Representative: **HOFFMANN EITLE**
**Patent- und Rechtsanwälte**
**Arabellastrasse 4**
**81925 München (DE)**

(56) References cited:
**EP-A1- 2 048 539**
**EP-A2- 2 103 966**
**US-A1- 2008 318 018**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

Field of the Invention

The present invention relates to a dispersion composition containing titanium black, a method of producing the dispersion composition, a photosensitive resin composition for a light-shielding color filter, a method of producing the photosensitive resin composition, a light-shielding color filter, a method of producing the light-shielding color filter, and a solid-state image sensor.

Color filters for use in liquid crystal displays are provided with a light-shielding film called black matrix for the purpose of shielding a space between colored pixels from light, improving contrast, or the like. In addition, solid-state image sensors are also provided with a light-shielding color filter for the purpose of preventing noise, improving image quality, or the like.

As a composition used for forming a black matrix for liquid crystal display devices, or a light-shielding color filter for solid-state image sensors, a photosensitive resin composition containing a black color material such as carbon black or titanium black is known. More specifically, as photosensitive resin compositions used mainly for liquid crystal displays, a photosensitive resin composition containing titanium black having a specific X-ray diffraction peak intensity ratio (for example, Japanese Patent No. 3724269 and International Patent Publication No. WO 2005/037926), or a photosensitive resin composition containing titanium black having a specific nitrogen concentration or a specific crystallite diameter (for example, Japanese Patent Application Laid-Open (JP-A) Nos. 2006-182627, 2006-206891, and 2006-209102) have been examined for the purpose of, for example, improving the optical density.

Furthermore, as photosensitive resin compositions for solid-state image sensors, a composition for forming a light-shielding film containing titanium black and a resin component is disclosed for the purpose of obtaining a thin film with high light-shielding properties (for example, JP-A No. 2007-115921). A method corresponding to the preamble of the appended Claim 1 is used in the preparation of the titanium black dispersions as described in paragraphs [0287] to [0290] of EP 2 103 966 A2.

SUMMARY OF THE INVENTION

As described above, titanium black is known as a black pigment, and it is thought that compositions including titanium black can form high-performance light-shielding films that have excellent light-shielding properties and insulation properties However, in the compositions including titanium black fine particles, the particles are likely to precipitate over time because the density of titanium black is high. Therefore, it is difficult to use titanium black in compositions intended for coating application.

The invention has been made in view of such circumstances and aims to address the following issues.

That is, according to an aspect of the invention, a dispersion composition is provided in which precipitation of titanium black particles is suppressed, which has excellent dispersion stability, and which inhibits the occurrence of coated surface abnormalities (i.e., leakage in light shielding) when the dispersion composition is made into a coating film, and a method of producing the same is also provided.

According to another aspect of the invention, a photosensitive resin composition for a light-shielding color filter is provided, which may be used to produce a light-shielding color filter that suppresses leakage in light shielding and has an excellent light-shielding capability, and a method of producing the same is also provided.

According to still another aspect of the invention, a light-shielding color filter is provided that suppresses leakage in light shielding and has an excellent light-shielding capability, and a method of producing the same is also provided.

According to still another aspect of the invention, a solid-state image sensor is provided that generates little noise and exhibits excellent color reproducibility.

Exemplary embodiments of the present invention are described below.

(1) A method of producing a dispersion composition comprising:

a first dispersion process of producing a dispersion liquid by subjecting a mixed liquid comprising titanium black, a dispersant, propylene glycol monomethyl ether acetate, and at least one solvent selected from the group consisting of butyl acetate, 2-heptanone, ethyl 3-ethoxypropionate, cyclohexanone, and propylene glycol monomethyl ether to a dispersion treatment without using a medium such as beads, sands or balls, wherein a content of the solvent in the mixed liquid is 5% by mass or more relative to the total content of the propylene glycol monoethyl ether acetate and the solvent; and

a second dispersion process of further subjecting the dispersion liquid obtained by the first dispersion treatment to a dispersion treatment using a medium such as beads, sands or balls.

(2) The method of producing a dispersion composition of (1), wherein the dispersant comprises a graft copolymer having a graft chain in which the total number of atoms other than hydrogen atoms is from 40 to 10,000.
(3) The method of producing a dispersion composition of (2), wherein the graft copolymer comprises a structural unit represented by at least one of the following Formulae (1) to (5):

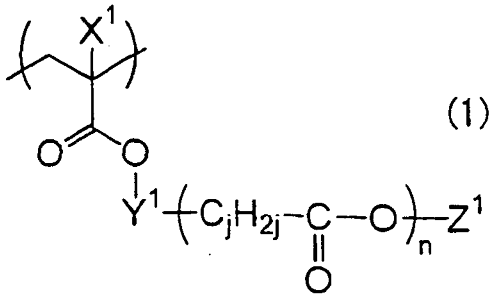
(1)

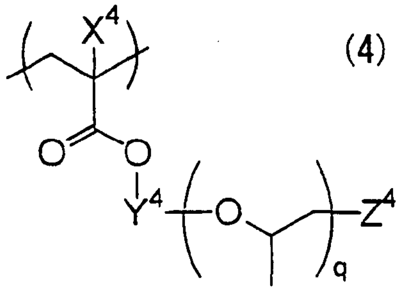
(4)

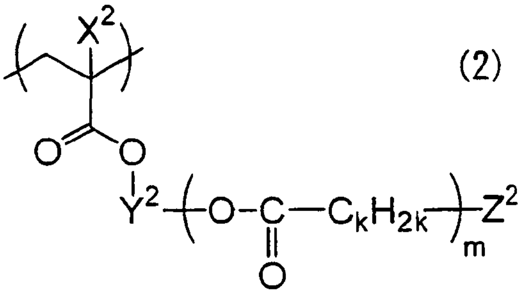
(2)

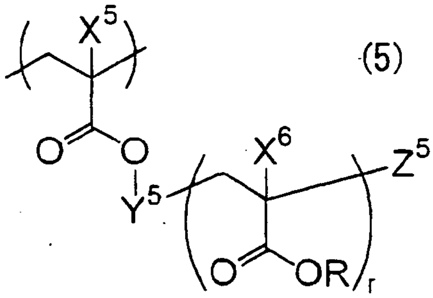
(5)

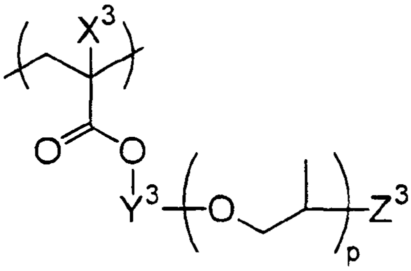
(3)

wherein, in Formulae (1) to (5), $X^1$, $X^2$, $X^3$, $X^4$, $X^5$, and $X^6$ each independently represents a hydrogen atom or a monovalent organic group; $Y^1$, $Y^2$, $Y^3$, $Y^4$, and $Y^5$ each independently represents a divalent linking group; $Z^1$, $Z^2$, $Z^3$, $Z^4$, and $Z^5$ each independently represents a monovalent organic group; R represents a hydrogen atom or a monovalent organic group, wherein two or more R's having different structures may be included in the graft copolymer; n, m, p, q, and r each independently represent an integer of from 1 to 500:
and j and k each independently represent an integer of from 2 to 8.
(4) The method of producing a dispersion composition of (2) or (3), wherein the graft copolymer comprises a structural unit represented by at least one of Formulae (1) to (5) in a range of from 10% to 90% by mass relative to the total mass of the graft copolymer.
(5) The method of producing a dispersion composition of any one of (1) to (4),
wherein the second dispersion process comprises:

subjecting the dispersion liquid obtained by the first dispersion process to a dispersion treatment until the change in volume average particle diameter of the titanium black becomes 10 nm/pass or less and adding a dispersant to the resulting dispersion liquid, to which a further dispersion treatment is then performed.

(6) A dispersion composition, obtainable by the method of producing a dispersion composition of any one of (1) to (5).
(7) A method of producing a photosensitive resin composition for a light-shielding color filter including titanium black,

a dispersant, a resin, a polymerizable compound, a photopolymerization initiator, propylene glycol monoethyl ether acetate, and at least one solvent selected from the group consisting of butyl acetate, 2-heptanone, ethyl 3-ethoxypropionate, cyclohexanone, and propylene glycol monomethyl ether, the method comprising:

a first dispersion process of producing a dispersion liquid by subjecting a mixed liquid comprising titanium black, a dispersant, propylene glycol monomethyl ether acetate, and at least one solvent selected from the group consisting of butyl acetate, 2-heptanone, ethyl 3-ethoxypropionate, cyclohexanone, and propylene glycol monomethyl ether to a dispersion treatment without using a medium, such as beads, sands or balls wherein a content of the solvent in the mixed liquid is 5% by mass or more relative to the total content of the propylene glycol monomethyl ether acetate and the solvent; and
a second dispersion process of further subjecting the dispersion liquid obtained by the first dispersion treatment to a dispersion treatment using a medium such as beads, sands or balls.

(8) A photosensitive resin composition for a light-shielding color filter, which is obtainable by the method of producing a photosensitive resin composition for a light-shielding color filter of (7).
(9) A use of the photosensitive resin composition of (8) for producing a color filter for a solid-state image sensor.
(10) A method of producing a light-shielding color filter, the method comprising:

applying the photosensitive resin composition for a light-shielding color filter of (8) to a support to form a photosensitive layer;
subjecting the photosensitive layer to pattern exposure; and
developing the photosensitive layer after the exposure to form a colored pattern.

(11) A light-shielding color filter, which is obtainable by the method of producing a light-shielding color filter of (10).
(12) A solid-state image sensor comprising the light-shielding color filter of (11).

According to the invention, there is provided a dispersion composition in which precipitation of titanium black particles is suppressed, which has excellent dispersion stability, and which inhibits the occurrence of coated surface abnormalities (i.e., leakage in light shielding) when the dispersion composition is made into a coating film, and a method of producing the same.
According to the invention, there is provided a photosensitive resin composition for a light-shielding color filter, which may be used to produce a light-shielding color filter that suppresses leakage in light shielding and has an excellent light-shielding capability, and a method of producing the same.
According to the invention, there is provided a light-shielding color filter that suppresses leakage in light shielding and has an excellent light-shielding capability, and a method of producing the same.
According to the invention, there is provided a solid-state image sensor that has little noise and exhibits excellent color reproducibility.

BRIEF DESCRIPTION OF THE DRAWINGS

Fig. 1 is a schematic diagram showing an example of a dispersion apparatus used for a first dispersion treatment and an example of the flow of a liquid to be treated (a mixed liquid).

DETAILED DESCRIPTION OF THE INVENTION

Hereinafter, the dispersion composition of the invention and the method of producing the same will be described in detail. Further, the photosensitive resin composition for a light-shielding color filter and the method of producing the same, the light-shielding color filter and the method of producing the same, and the solid-state image sensor of the invention will be described in detail,

*Dispersion composition and method for producing the same*

According an exemplary embodiment of the invention, the method of producing a dispersion composition includes:

a first dispersion process of performing a dispersion treatment on a mixed liquid containing at least titanium black, a dispersant, propylene glycol monomethyl ether acetate (which may be referred to as "solvent 1" hereinafter), and at least one solvent (which may be referred to as "solvent 2" hereinafter) selected from the group consisting of butyl

acetate, 2-heptanone, ethyl 3-ethoxypropionate, cyclohexanone, and propylene glycol monomethyl ether, without using a medium, wherein the content of the solvent 2 is 5% by mass or more with respect to the total content of the solvents 1 and 2; and

a second dispersion process of performing an additional dispersion treatment, using a medium, on a dispersion liquid obtained by the first dispersion process.

The method of producing a dispersion composition of the invention may have other additional processes.
Further, the dispersion composition of the invention is a composition produced by the method of producing a dispersion composition of the invention.

Generally, titanium black particles included in a dispersion composition easily precipitate with the passage of time as compared to a case of a dispersion composition including carbon black particles. As a result, the dispersion composition including titanium black as particles tends to have a low dispersion stability.
As a result of study by the inventor of the present invention, it has been found out that the precipitation of titanium black (particles) may be suppressed and the dispersion stability may be improved, by performing a dispersion treatment without using a medium (i.e., a dispersion treatment corresponding to the first dispersion process) as a pretreatment of a dispersion treatment using a medium (i.e., a dispersion treatment corresponding to the second dispersion process). Further, it has been found that when the dispersion method is applied to a titanium black dispersion composition obtained by using the solvent 1 generally used as a solvent component of a photosensitive resin composition for a color filter, coated surface abnormalities (i.e., leakage in light shielding) tend to occur easily in a coating film formed using the dispersion composition. The reason is thought to be the generation of bubbles in the obtained dispersion composition during the treatments of the first dispersion process and the second dispersion process; however, the invention is not limited by the reason.
When the dispersion composition and the method of producing the same have the configurations of the invention, the precipitation of titanium black particles is suppressed, the dispersion stability is improved, and the occurrence of coated surface abnormalities (i.e., leakage in light shielding) of a coated film obtained using the dispersion composition is inhibited.

*First dispersion process*

The first dispersion process in the invention is a process of applying a dispersion treatment to the mixed liquid without using a medium. Specifically, in the first dispersion process, the mixed liquid is subjected to a dispersion treatment without using a medium.
Here, the recitation "performing a dispersion treatment without using a medium" means that a dispersion treatment is carried out using substantially no dispersion medium (such as beads, sands, or balls) and, instead, utilizing shear force (such as the shear force applied by a disperser).
Here, the recitation "using substantially no medium (or no dispersion medium)" means that a dispersion medium may be mixed into the mixed liquid as long as the content of the dispersion medium is so small that it does not contribute to the dispersion process.
In an example of an embodiment of performing a dispersion treatment utilizing shear force applied by a disperser, shear force is applied to a liquid to be treated (a mixed liquid) by allowing the liquid to pass through a space sandwiched between a stationary unit having a concentric cylindrical shape and a rotation unit in a dispersion apparatus as shown in Fig. 1.

In the first dispersion process, it is preferable to perform the dispersion treatment under the condition that the number of coarse particles having a volume average particle diameter of 0.1 $\mu$m or more is 1,000 particles or less per 1 $\mu$L of the liquid to be treated (or the mixed liquid) after completion of the first dispersion process.
Specifically, it is preferable to perform the dispersion treatment of the first dispersion process at a shear rate of From 150,000 to 350,000 (1/s), and more preferably at a shear rate of from 175,000 to 300,000 (1/s), from the viewpoint of more effectively obtaining the effects of the invention.
Herein, the term "shear rate" means a value calculated by the following expression: speed of rotation unit/(gap between rotation unit and stationary unit). Herein, the term "speed of rotation unit" means a value calculated from the radius of rotation and the rotational frequency of the rotation unit, according to the following expression: 3.14 $\times$ radius (m) $\times$ rotational frequency (1/s).
It is preferable that the treatment is uniformized by ensuring that all the liquid to be treated passes through the gap of Fig. 1 in the embodiment using the Dispersion apparatus of Fig. 1.
When the shear rate is 150,000 (1/s) or more, the precipitation of titanium black may be further suppressed, the number of coarse particles may be further reduced, and the temporal stability of a composition may be further improved.
When the shear rate is 350,000 (1/s) or less, the occurrence of coated surface abnormalities (i.e., leakage in light shielding) may be further suppressed.

A high-shear circulation type disperser to be used for the first dispersion process is not particularly limited. Examples thereof include MAGICLAB (trade name, manufactured by IKA), FILMIX (trade name, manufactured by PRIMIX Corporation), and SS5 (trade name, manufactured by M Technique Co., Ltd.).
The treatment time of the first dispersion process is preferably from 5 minutes to 2 hours, and more preferably from 20 minutes to 1 hour.
An object that is to be dispersed in the first dispersion process is a mixed liquid containing titanium black, a dispersant, and the solvents 1 and 2, in which the content of the solvent 2 is 5% by mass or more with respect to the total content of the solvents 1 and 2.
The solvent 2 may be a single-component solvent or a mixture of multiple solvents.
The dispersant is preferably a graft copolymer having a graft chain in which the total number of atoms thereof except hydrogen atoms is from 40 to 10,000.
Details of respective components including titanium black, the dispersant, the solvents 1 and 2 will be described hereinafter.
Further, the mixed liquid may contain other additional components such as components of the photosensitive resin composition which will be described later (e.g., a resin, a photopolymerization initiator, and a polymerizable compound), in addition to the titanium black, the dispersant, and the solvents 1 and 2.

*Second dispersion process*

The second dispersion process in the invention is a step of applying a dispersion treatment to the dispersion liquid obtained by the first dispersion process, using a medium. Specifically, in the second dispersion process, the dispersion liquid that has been subjected to the first dispersion process is subjected to a dispersion treatment using a dispersion medium.
In the second dispersion process, it is preferable that the dispersion treatment is performed under the condition that the number of coarse particles having a volume average particle diameter of 0.1 μm or more is 1,000 particles or less per 1 μL of the liquid to be treated (or the mixed liquid) after completion of the second dispersion process.
Any known dispersion medium (e.g., beads, sands, or balls) may be used as the medium.
The composition and size (i.e., diameter) of the beads are not particularly limited. Any beads having a known composition or a known diameter may be used. For example, beads having a diameter of from 0.01 to 0.10 mm are suitably used as the bead dispersion medium.
The dispersion apparatus to be used for the second dispersion process is not particularly limited. Usable examples of the dispersion apparatus include dispersion apparatuses, such as a circulation dispersion apparatus, which enable repeated dispersion treatment of the dispersion liquid obtained by the first dispersion process. Specific examples of dispersion apparatuses include ULTRA APEX MILL (trade name, manufactured by Kotobuki Industries Co., Ltd.) and DYNO-MILL ECM series (trade name, manufactured by Shinmaru Enterprises Corporation).
The temperature at the time of performing the dispersion treatment is not particularly limited, and is preferably from 5 to 60°C, and more preferably from 20 to 40°C, from the viewpoint of dispersion stability.
In the second dispersion process, the dispersion treatment of the dispersion liquid obtained by the first dispersion process may be started after an additional component such as a solvent or a dispersant has been added to the dispersion liquid, or the dispersion treatment may be started before such a component is added. The solvent and dispersant to be added may be the same as or different from the solvent and dispersant included in the mixed liquid which is to be treated in the first dispersion process, respectively.
In an embodiment of the second dispersion process, the dispersant (and the solvent, if necessary) may be added during the dispersion treatment, and the dispersion treatment may be further continued after the addition thereof (hereinafter, such a dispersion treatment is referred to as a "multistage dispersion treatment").
In the second dispersion process which takes the embodiment of a multistage dispersion treatment, first, a dispersion treatment is performed, using a medium, on the dispersion liquid obtained by the first dispersion process (hereinafter, this dispersion treatment may be referred to as a "first stage of dispersion treatment"), and then, a dispersant is added to the dispersion liquid obtained by this dispersion treatment (i.e., the first stage of dispersion treatment), and a dispersion treatment is further performed (hereinafter, this dispersion treatment may be referred to as a "second stage of dispersion treatment").
In the second dispersion process which takes the embodiment of a multistage dispersion treatment, a third or additional subsequent stage of dispersion treatment may be performed after further addition of a dispersant after the second stage of dispersion treatment, or further addition of a dispersant may be performed during a third or additional subsequent stage of dispersion treatment after the second stage of dispersion treatment.
Herein, the multistage dispersion treatment refers to a dispersion treatment in which the ratio (D/P ratio) of an amount of dispersant (D) to an amount of titanium black (P) increases with each stage of the first stage, the second stage, and later stages of the dispersion treatment. In this regard, a dispersion treatment in which the D/P ratio does

not increase with each stage of the dispersion treatment is not included in the multistage dispersion treatment of the invention. For example, a dispersion treatment in which a dispersion treatment is suspended at some point, and, after some time, the dispersion is simply re-started at the same D/P ratio, or a dispersion treatment in which multiple dispersion treatments are conducted by changing the disperser, the type of beads, the amount of beads, or the like without changing the D/P ratio, are not included in the multistage dispersion treatment of the invention.
Hereinafter, the first stage of dispersion treatment and the second stage of dispersion treatment of a multistage dispersion treatment performed as the second dispersion process will be described in detail.

*First stage of dispersion treatment*

The first stage of dispersion treatment is a dispersion treatment in which a dispersion liquid obtained by the first dispersion process is dispersed.
Preferable conditions (e.g., an apparatus, the temperature, or the like) of the first stage of dispersion treatment are substantially the same as those of the second dispersion process.

In the first stage of dispersion treatment, the ratio (D/P ratio) (mass ratio) of an amount of the dispersant (D) to an amount of the titanium black (P) in the mixed liquid is preferably from 0.05 to 1.00. and more preferably from 0.05 to 0.50. When the D/P ratio is adjusted so as not to be excessively high, for example, to 1.00 or lower, the process of dispersion can be accelerated. When the D/P ratio is adjusted to 0.05 or more, the dispersion stability can be improved.

In the first stage of dispersion treatment, the volume average particle diameter of titanium black after the dispersion treatment is preferably from 0.005 μm to 0.03 μm, and more preferably from 0.01 μm to 0.02 μm. The volume average particle diameter of titanium black is determined by a dynamic light scattering method using a diluted liquid obtained by 80-fold diluting a mixed liquid or dispersion liquid containing titanium black with propylene glycol monomethyl ether acetate. The measurement may be performed using MICROTRAC UPA-EX150 (trade name, manufactured by Nikkiso Co., Ltd.).

The mass ratio of the solvent to the titanium black (solvent/titanium black) of the mixed liquid to be used in the first stage of dispersion treatment is preferably from 1.0 to 9.0, and more preferably from 1.0 to 5.0, in view of easiness in dispersibility.

*Second stage of dispersion treatment*

The second stage of dispersion treatment is a dispersion treatment in which a dispersant is added to the dispersion liquid obtained by the first stage of dispersion treatment and a dispersion treatment is further performed.

In the second stage of dispersion treatment, a dispersion treatment of titanium black is further performed using a part or all of the remainder of the initial dispersant (i.e., the amount obtained by subtracting the amount of the dispersant used in the first stage of dispersion treatment from the total amount of the initial dispersant). In this case, the dispersant used in the second state of dispersion treatment may be the same as or different from the dispersant used in the first stage of dispersion treatment.

In the second stage of dispersion treatment, the mass ratio (D/P ratio) of an amount of the second dispersant (D) to an amount of the titanium black (P) in the mixed liquid is preferably from 0.05 to 1.00, and more preferably from 0.05 to 0.50. When the D/P ratio is adjusted so as not to be excessively high, for example, to 1.00 or lower, the process of dispersion can be accelerated. When the D/P ratio is adjusted to 0.05 or more, the dispersion stability can be improved.

The timing at which the dispersant is added in the second stage of dispersion treatment is not particularly limited. From the viewpoint of the dispersibility-improving effect (that is, the effect of preventing aggregation of titanium black) of plural-batch addition of the dispersant, the dispersant is preferably added after the change in the volume average particle diameter of titanium black reaches 10 nm/pass or less.
In this regard, the dispersant may be added only once or may be added in two or more separate batches in the second stage of dispersion treatment. The timing of subsequent additions can be delayed after the change in the volume average particle diameter reaches 10 nm/pass or less.

Herein, the term "10 nm/pass or less" means that the change in the volume average particle diameter per pass in a dispersion apparatus is 10 nm or less. An example of a state of "10 nm/pass or less" includes the following state. That is, in a system in which the volume average particle diameter decreases with respect to each pass at the beginning of the dispersion treatment of the mixed liquid, and the change in the volume average particle diameter decreases with respect to each pass as the dispersion progresses, a state in which the amount of change in the volume average particle diameter with respect to each pass reaches 10 nm or less, is indicated by "10 nm/pass or less".
Here, the term "pass" refers to the number of times the total volume of the dispersion liquid is allowed to pass through the dispersion apparatus. For example, when 25 L (liter) of a mixed liquid is dispersed at a flow rate of 5 L/h in a dispersion apparatus, a 5-hour dispersion treatment is defined as "one pass". The number of times of passes is determined by the following Equation (A).

$$\text{Equation (A):} \quad \text{Number of times of passes} = (\text{flow rate [L/h]} \times \text{treatment time [h]})/\text{amount of liquid to be treated [L]}$$

In the second stage of dispersion treatment, a solvent may be added in addition to a dispersant. The solvent to be added in the second stage of dispersion treatment may be the same as or different from the solvent(s) included in the mixed liquid that is to be treated in the first stage of dispersion treatment (i.e., the solvent to be added in the second stage of dispersion treatment may be the solvent 1 and/or 2, or may be a solvent other than the solvents 1 and 2). The solvents 1 and/or 2 are/is preferably used as the solvent to be added in the second stage of dispersion treatment. Here, when the solvent 1 is used in combination with the solvent 2, the mass ratio thereof (i.e., "solvent 1/solvent 2") may be the same as or different from the mass ratio thereof used in the first stage of dispersion treatment.
Further, in the second stage of dispersion treatment, components of the photosensitive resin composition which will be described later (e.g., a resin, a photopolymerization initiator, or a polymerizable compound) may be added, in addition to the dispersant and solvent.
Preferable conditions (e.g., an apparatus, the temperature, or the like) of the second stage of dispersion treatment are substantially the same as those of the first stage of dispersion treatment. However, the conditions of the first stage of dispersion treatment and the conditions of the second stage of dispersion treatment may be the same as or different from each other.
In an embodiment of the invention, the method of producing a dispersion composition may include, after the first or second dispersion process, an additional dispersion process in which the dispersion liquid obtained by the first or second dispersion process is subjected to an additional dispersion treatment. In the additional dispersion treatment performed in the additional dispersion process, a medium may or may not be used; but it is preferable that a medium is used in the additional dispersion treatment.
The dispersion composition of the invention (hereinafter referred to as "final dispersion composition") is obtained through the first dispersion process and the second dispersion processes (which is preferably the multistage dispersion).
The total content of solvents included in the obtained final dispersion composition is preferably from 30 to 95% by mass, preferably from 40 to 90% by mass, and particularly preferably from 50 to 80% by mass, with respect to the total mass of the composition.
The ratio (D/P ratio) of the dispersant (D) to the titanium black (P) which are included in the obtained final dispersion composition is preferably from 0.2 to 1.2. When the D/P ratio is 0.2 or more, the dispersion stability is further improved. When the D/P ratio is 1.2 or less, it is advantageous in terms of the microparticulation of pigment caused by the progression of dispersion. Specifically, the D/P ratio is preferably from 0.2 to 0.8, and particularly preferably from 0.2 to 0.5, from the same reason.
The content of titanium black in the obtained final dispersion composition is preferably from 5 to 80% by mass, more preferably from 5 to 50% by mass, and particularly preferably from 5 to 30% by mass, with respect to the total mass of the composition.
Hereinafter, respective components of the dispersion composition of the invention, such as a titanium black, dispersant, or a solvent, and the method of producing the same will be described in detail.

*Titanium black*

Titanium black used in the invention is black particles (black pigment) including a titanium atom. Titanium black is preferably a low-order titanium oxide or a titanium oxynitride represented by $TiN_xO_y$ (wherein x and y each represent a real number of less than 2).
The surface of titanium black may be modified, if necessary, for the purpose of improvement in dispersibility, suppression of aggregation, and the like. Specifically, the surface may be coated with silicon oxide, titanium oxide, germanium oxide, aluminum oxide, magnesium oxide, zirconium oxide, or the like. Alternatively, the surface may be treated with a water repellent substance described in JP-A No. 2007-302836.
Examples of methods of producing titanium black include, but not limited to, a method of heating and reducing a mixture of titanium dioxide and titanium metal in a reduction atmosphere (see, for example, JP-A No. 49-5432), a method in which ultrafine particles of titanium dioxide is obtained by hydrolysis of titanium tetrachloride at high temperatures and then reduced in a reduction atmosphere containing hydrogen (see, for example, JP-A No. 57-205322), a method of reducing titanium dioxide or titanium hydroxide at high temperatures in the presence of ammonia (see, for example, JP-A Nos. 60-65069 or 61-201610), and a method of attaching a vanadium compound to titanium dioxide or titanium hydroxide and reducing it at high temperatures in the presence of ammonia (see, for example, JP-A No. 61-201610).
An average primary particle diameter of titanium black is not particularly limited, and it is preferably from 3 nm

to 2000 nm, more preferably from 10 nm to 500 nm, and particularly preferably from 10 nm to 100 nm, from the viewpoint of dispersibility and colorability.

The specific surface area of titanium black is not particularly limited. In order to make water repellency a predetermined performance after the titanium black is subjected to a surface treatment using a water repellent agent, a specific surface area of titanium black measured by the BET method is usually from about 5 to 150 $m^2/g$, and particularly preferably from about 20 to 100 $m^2/g$.

Examples of commercial products of the titanium black include TITANIUM BLACK 10S, 12S, 13R, 13M, 13 M-C, 13R, 13 R-N, and 13 M-T (all trade names, manufactured by Mitsubishi Materials Corporation or Jemco Co., Ltd.) and TILACK D (trade name, manufactured by AKO KASEI CO., LTD).

A single species of titanium black may be used alone, or a combination of two or more species thereof may be used.

Further, an extender pigment may be added to titanium black, if necessary.

Examples of extender pigments include barium sulfate, barium carbonate, calcium carbonate, silica, basic magnesium carbonate, alumina white, gloss white, titanium white, and hydrotalcite. Any one of these extender pigments may be used alone, or a mixture of two or more of them may be used. The amount of the extender pigments to be used is usually from 0 part by mass to 100 parts by mass, preferably from 5 to 50 parts by mass, and further preferably from 10 to 40 parts by mass, with respect to 100 parts by mass of titanium black.

If necessary, the surfaces of the titanium black and the extender pigment may be modified using a polymer before use.

The dispersion composition of the invention may include, as a light-shielding pigment, a light-shielding pigment other than titanium black. The light-shielding pigment other than titanium black is not particularly limited as long as it has absorbance in a visible light region, and may be an organic pigment or an inorganic pigment. Examples of the light-shielding pigment other than titanium black include the extender pigments described above, carbon black (C. I. Pigment Black 7), C.I. Pigment Blue 1, 2, 15, 15:1, 15:2, 15:3, 15:4, 15:6, 16, 22, 60, 64, 66, 79, 80, C.I. Pigment Violet 1, 19, 23. 27, 32, 37, 42, C.I. Pigment Brown 25, 28, and C.I. Pigment Black 1. Examples of combinations of titanium black and a light-shielding pigment other than titanium black include a mixture of titanium black with carbon black at a ratio of 6:1 and a mixture of titanium black with titanium oxide at a ratio of 3:1. The amount of light-shielding pigments other than titanium black which are mixed may be in the range of from 0.01 part by mass to 99.99 parts by mass, and preferably in the range of from 20 to 70 parts by mass, with respect to 100 parts by mass of titanium black.

*Solvent component*

The mixed liquid to be treated in the first dispersion process in the invention includes, as solvent components, propylene glycol monomethyl ether acetate (the solvent 1) and at least one solvent (the solvent 2) selected from the group consisting of butyl acetate, 2-heptanone, ethyl 3-ethoxypropionate, cyclohexanone, and propylene glycol monomethyl ether.

In the mixed liquid, the content of the solvent 2 is 5% by mass or more based on the total amount of the solvents 1 and 2.

In the mixed liquid, the content of the solvent 2 is preferably 10% by mass or more, more preferably 20% by mass or more, and particularly preferably 25% by mass or more, with respect to the total content of the solvents 1 and 2, from the viewpoint of further inhibiting the occurrence of coated surface abnormalities.

The upper limit of the content of the solvent 2 with respect to the total content of the solvents 1 and 2 is preferably 60% by mass, and more preferably 50% by mass, from the viewpoint of dispersion stability.

From the viewpoint of further inhibiting the occurrence of coated surface abnormalities, the solvent 2 is more preferably at least one selected from the group consisting of butyl acetate, 2-heptanone, ethyl 3-ethoxypropionate, and propylene glycol monomethyl ether, and particularly preferably at least one selected from the group consisting of butyl acetate and ethyl 3-ethoxypropionate.

If necessary, the mixed liquid may contain other solvents, other than the solvents 1 and 2.

Examples of other additional solvents include acetone, methyl ethyl ketone, cyclohexane, ethyl acetate, ethylene dichloride, tetrahydrofuran, toluene, ethylene glycol monomethyl ether, ethylene glycol monoethyl ether, etlhylene glycol dimethyl ether, propylene glycol monoethyl ether, acetylacetone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxy methoxy ethanol, diethylene glycol monoethyl ether, diethylene glycol monoethyl ether, diethylene glycol dimethyl ether, diethylene glycol diethyl ether, propylene glycol monoethyl ether acetate, 3-methoxypropylacetate, N.N-dimethylformamide, dimethyl sulfoxide, $\gamma$-butyrolactone, ethyl acetate, methyl lactate, and ethyl lactate.

The total content of the solvent components included in the mixed liquid (i.e., the solvents 1 and 2, and an additional solvent which may be added if necessary) is preferably from 20 to 70% by mass, more preferably from 30 to 60% by mass, and particularly preferably from 40 to 50% by mass, with respect to the total amount of the mixed liquid.

A solvent component(s) may be additionally added at the time of the start of the second dispersion process and/or during the second dispersion process. The solvent component(s) to be additionally added may be the solvent 1

and/or the solvent 2, or may be any one of the additional solvents.

*Dispersant*

The dispersant used in the invention is at least a dispersant included in the mixed liquid to be treated in the first dispersion process.
However, the dispersant may be additionally added in the second dispersion process in an embodiment of the multistage dispersion treatment (i.e., multistage dispersion treatment), or may be additionally added at the start of the second dispersion process.
When the dispersant is additionally added, the dispersant to be additionally added may be the same as or different from the dispersant included in the mixed liquid.
Regarding the dispersant included in the mixed liquid and the dispersant to be additionally added thereto, only single species of the dispersant may be used, or a combination of two or more species thereof may be used, respectively.
Examples of dispersants used in the invention include: polymer dispersants such as polyamidoamine and a salt thereof, polycarboxylic acid and a salt thereof, high-molecular-weight unsaturated acid ester, modified polyurethane, modified polyester, modified poly(meth)acrylate, (meth)acryl copolymer, and naphthalenesulfonic acid-formalin condensate; polyoxyethylene alkyl phosphate; polyoxyethylene alkylamine; alkanolamine; and pigment derivatives.
The dispersant used in the invention may be classified into a linear polymer, a terminal-modified polymer, a graft polymer, and a block polymer, depending on its structure.
The dispersant used in the invention adsorbs on the surfaces of titanium black and an optional pigment to be used in combination with titanium black, and acts to prevent reaggregation. Therefore, examples of preferable structures of the dispersant include a terminal-modified polymer, a graft polymer, and a block polymer, which have an anchoring moiety to the pigment surface.
On the other hand, an effect of promoting adsorption of a dispersion resin may be imparted to the dispersant by modifying the pigment surface.
Specific examples of dispersants to be used in the invention include: DISPERBYK 101 (polyamide amine phosphate), 107 (carboxylic acid ester), 110 (acid group-containing copolymer), 130 (polyamide), 161, 162, 163, 164, 165, 166, 170, and 180 (high-molecular copolymer) (trade name, manufactured by BYK Chemie); BYK-P104 and P105 (high-molecular-weight unsaturated polycarboxylic acid) (trade name, manufactured by BYK Chemie); EFKA4047, 4050, 4010, and 4165 (polyurethane compound), EFKA 4330, 4340 (block copolymer), 4400, 4402 (modified polyacrylate), 5010 (polyester amide), 5765 (high-molecular-weight polycarboxylate), 6220 (fatty acid polyester), 6745 (phthalocyanine derivative), and 6750 (azo pigment derivative) (trade name, manufactured by EFKA); AJISPER PB821 and PB822 (trade name, manufactured by Ajinomoto Fine-Techno Co., Inc.); FLOWLEN TG-710 (urethane oligomer) and POLYFLOW Nos. 50E and 300 (acrylic copolymer) (trade name, manufactured by Kyoeisha Chemical Co., Ltd.); DISPARLON KS-860, 873SN, 874, #2150 (aliphatic polycarboxylic acid), #7004 (polyether ester), DA-703-50, DA-705, and DA-725 (trade name, manufactured by Kusumoto Chemicals, Ltd.); DEMOL RN, N (naphthalenesulfonic acid formalin polycondensate), MS, C, SN-B (aromatic sulfonic acid formalin polycondensate), HOMOGENOL L-18 (high-molecular polycarboxylic acid), EMULGEN 920, 930, 935, and 985 (polyoxyethylene nonyl phenyl ether), and ACETAMIN 86 (stearylamine acetate) (all trade names, manufactured by Kao Corporation); SOLSPERSE 5000 (phthalocyanine derivative), 22000 (azo pigment derivative), 13240 (polyester amine), 3000, 17000, 27000 (polymer having a functional moiety at a terminal thereof), 24000, 28000, 32000, and 38500 (graft polymers) (trade name, manufactured by The Lubrizol Corporation); and NIKKOL T106 (polyoxyethylene sorbitan monooleate) and MYS-IEX (polyoxyethylene monostearate) (trade name, manufactured by Nikko Chemicals Co., Ltd.).
Any one of these dispersants may be used alone, or a combination of two or more thereof may be used.
The acid value of the dispersant is preferably from 5.0 to 200 mgKOH/g, more preferably from 10 to 150 mgKOH/g, and further preferably from 60 to 150 mgKOH/g. When the acid value is 200 mgKOH/g or less, the releasing of a pattern at the time of development is suppressed. When the acid value is 5.0 mgKOH/g or more, favorable alkali development properties are obtained. When the acid value is 60 mgKOH/g or more, the precipitation of titanium black may be further suppressed, the number of coarse particles may be further reduced, and the temporal stability of composition may be further improved.
In the invention, the acid value of the dispersant may be calculated, for example, from the average content of acid groups in the dispersant. A resin having a desired acid value may be obtained by changing the content of monomer units containing an acid group, which constitute the dispersant.
The weight average molecular weight of the dispersant used in the invention is preferably from 10,000 to 300,000, more preferably from 15,000 to 200,000, further preferably from 20,000 to 100,000, and particularly preferably from 25,000 to 50,000 from the viewpoint of suppression of the releasing of a pattern at the time of development and development properties. The weight average molecular weight of dispersant may be measured, for example, by GPC.

*Graft copolymer*

In an embodiment of the invention, it is preferable to use a graft copolymer (hereinafter referred to as "specific resin") as a dispersant.
The dispersibility and storage stability may be further improved by using the graft copolymer as a dispersant.

It is preferable that the graft copolymer have a graft chain having the total number of atoms except hydrogen atoms of from 40 to 10,000. In this case, the graft chain means a chain from the bottom of the main chain of a copolymer to the terminal of a group branched from the main chain.
In the dispersion composition, the specific resin is a dispersion resin which imparts dispersibility to titanium black. Since the specific resin has an excellent dispersibility and affinity to a solvent due to the graft chain, the specific resin is excellent in dispersibility of titanium black and dispersion stability after the passage of time. When the specific resin is made into a photosensitive resin composition, the specific resin has an affinity to a polymerizable compound or other resins usable in combination therewith, due to the graft chain; therefore, residues are hardly produced in alkaline development.

Further, a function as a resin that provides development properties required for forming a pattern by alkaline development may be imparted to the specific resin by introducing an alkali-soluble partial structure such as a carboxylic group into the specific resin. Therefore, in the photosensitive resin composition of the invention, the dispersion resin itself, which is essential to the dispersion of titanium black, has an alkali solubility by introducing an alkali-soluble partial structure into the graft copolymer. Such a photosensitive resin composition is preferable in that it is excellent in light-shielding properties of the exposure portion and alkali development properties of the unexposed portion are improved.

When a longer graft chain is employed, the steric repulsion effect is increased and the dispersibility is improved. On the other hand, when the graft chain is too long, the adsorbability to titanium black is lowered and the dispersibility is reduced. Thus, it is preferable that the graft copolymer to be used in the invention have the total number of atoms except hydrogen atoms per one graft chain of preferably from 40 to 10,000, more preferably from 50 to 2,000, and further preferably from 60 to 500 per graft chain.

Any one of poly(meth)acryl, polyester, polyurethane, polyurea, polyamide, and polyether structures or the like may be used as a polymer structure of the graft chain. In order to improve interaction of the graft moiety and the solvent and further increase dispersibility, the polymer structure is preferably a poly(meth)acrylic structure, or a graft chain having a poly(meth)acryl, polyester, or polyether structure, or more preferably a graft chain having a polyester or polyether structure is preferably used.

The structure of a macromonomer having such a polymer structure as a graft chain is not particularly limited as long as it has a substituent which can react with a polymer main chain portion and satisfies the requirement of the invention. Preferably, a macromonomer having a reactive double bonding group may be suitably used.

Examples of commercial products of macromonomers to be suitably used for synthesis of the specific resin include: macromonomers AA-6, AA-10, AB-6, AS-6, AN-6, AW-6, AA-714, AY-707, AY-714, AK-5, AK-30, and AK-32 (trade names, manufactured by TOAGOSEI CO., LTD.); and macromonomers BLENMER PP-100, BLENMER PP-500, BLENMER PP-800, BLENMER PP-1000, BLENMER 55-PET-800, BLENMER PME-4000, BLENMER PSE-400, BLENMER PSE-1300, and BLENMER 43PAPE-600B (trade names, manufactured by NOF CORPORATION), Among them, AA-6, AA-10, AB-6, AS-6, and AN-6 (trade names, manufactured by TOAGOSEI CO., LTD.) and BLENMER PME-4000 (trade name, manufactured by NOF CORPORATION) are preferably used.

It is preferable that the graft moiety of the specific resin to be used in the invention includes a structural unit represented by at least one of Formulae (1) to (5), and more preferably includes a structural unit represented by at least one of Formula (1A), (2A), (3), (4) and (5).

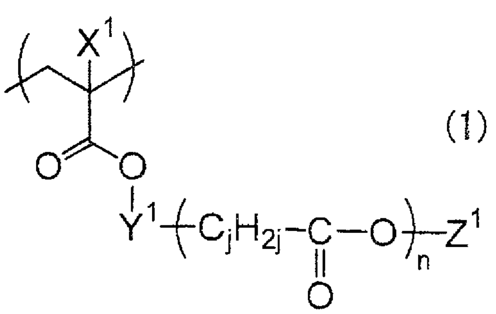
(1)

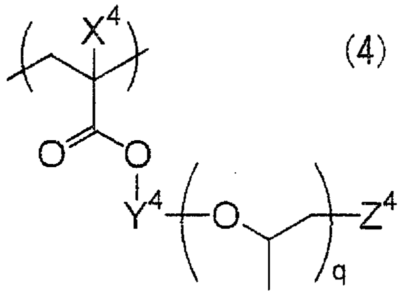
(4)

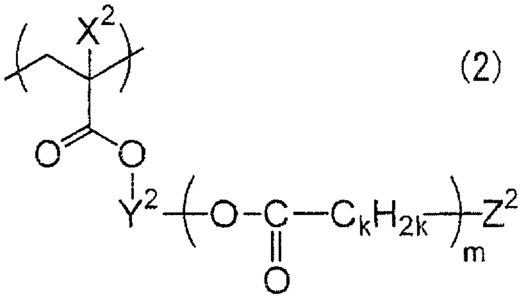

(2)

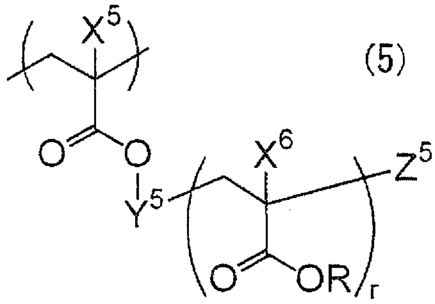

(5)

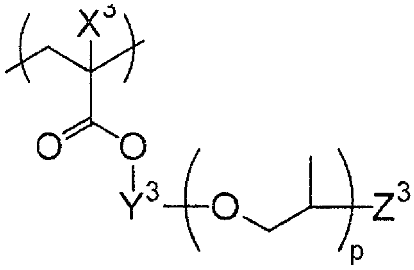

(3)

In Formulae (1) to (5), $X^1$, $X^2$, $X^3$, $X^4$, $X^5$, and $X^6$ each independently represents a hydrogen atom or a monovalent organic group. From the viewpoint of the limitations of synthesis, $X^1$, $X^2$, $X^3$, $X^4$, $X^5$, and $X^6$ each independently represents preferably a hydrogen atom or an alkyl group having 1 to 12 carbon atoms, more preferably a hydrogen atom or a methyl group, and particularly preferably a methyl group.

In Formulae (1) to (5), $Y^1$, $Y^2$, $Y^3$, $Y^4$, and $Y^5$ each independently represents a divalent linking group, the structures of which are not particularly restricted. Specific examples of the linking groups include the linking groups represented by (Y-1) to (Y-20) shown below. In the following structures, A indicates a bond with the oxygen atom just above any one of $Y^1$ to $Y^3$ in Formulae (1) to (5), and B indicates a bond with the oxygen or carbon atom at the right side of any one of $Y^1$ to $Y^5$ shown in Formulae (1) to (5). Among the structures shown below, (Y-2) and (Y-13) are morse preferable from the viewpoint of ease of synthesis.

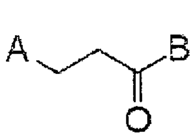

(Y-1)

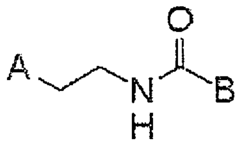

(Y-2)

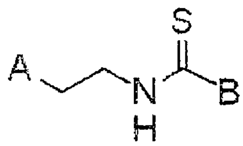

(Y-3)

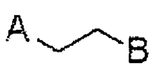

(Y-4)

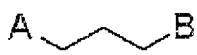

(Y-5)

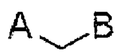

(Y-6)

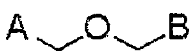

(Y-7)

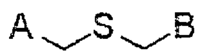

(Y-8)

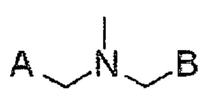

(Y-9)

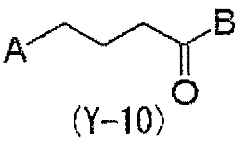
(Y-10)

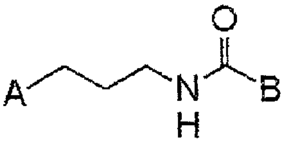
(Y-11)

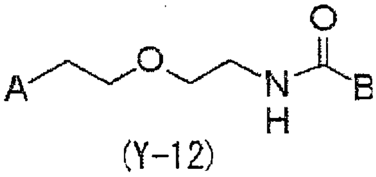
(Y-12)

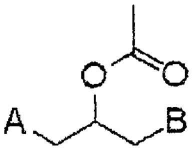
(Y-13)

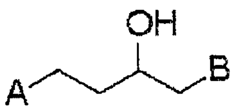
(Y-14)

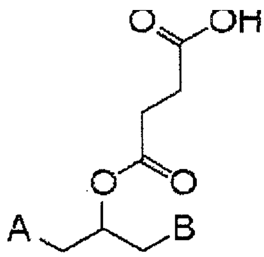
(Y-15)

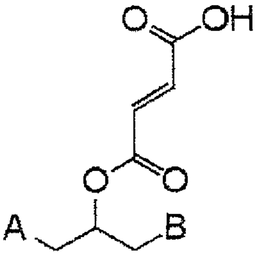
(Y-16)

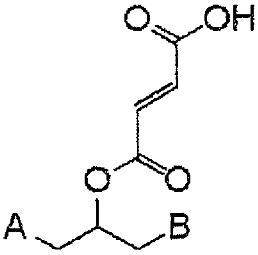
(Y-17)

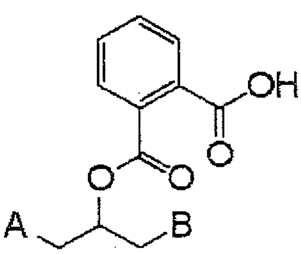
(Y-18)

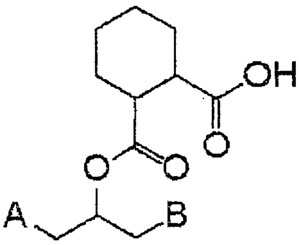
(Y-19)

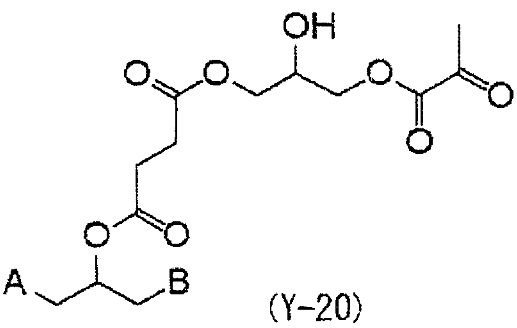
(Y-20)

In Formulae (1) to (5), $Z^1$, $Z^2$, $Z^3$, $Z^4$, and $Z^5$ independently represent a monovalent organic group, and their structures are not particularly limited. Specific examples of the monovalent organic group include a hydroxyl group, an alkyl group, an alkoxy group, an aryloxy group, a heteroaryloxy group, an alkylthio ether group, an arylthio ether group, a heteroaryl thioether group, and an amino group. Among them, it is preferable that $Z^1$ to $Z^5$ each have a stereo-repulsion effect from the viewpoint of improvement in dispersibility, and it is preferable that $Z^1$ to $Z^5$ independently represent an alkyl group having 5 to 24 carbon atoms, more preferably a branched alkyl group having 5 to 24 carbon atoms or a cyclic alkyl group having 5 to 24 carbon atoms.

In Formulae (1) to (5), n, m, p, q, and r each represent an integer from 1 to 500.

In Formula (1) and (2), j and k each independently represent an integer of from 2 to 8, and from the viewpoints of dispersion stability and developability, j and k each independently represent preferably an integer of from 4 to 6, and most preferably 5.

In Formula (5), R represents a hydrogen atom or a monovalent organic group, and the structure of R is not particularly limited. R is preferably a hydrogen atom, an alkyl group, an aryl group, or a heteroaryl group, and more

preferably a hydrogen atom or an alkyl group. When R represent an alkyl group, examples thereof include a straight-chain alkyl group having 1 to 20 carbon atoms, a branched alkyl group having 3 to 20 carbon atoms, and a cyclic alkyl group having 5 to 20 carbon atoms, and R is more preferably a straight-chain alkyl group having 1 to 20 carbon atoms, and particularly preferably a straight-chain alkyl group having 1 to 6 carbon atoms.
In Formula (5), two or more R's having different structures from one another may be included in the specific resin.

From the viewpoints of dispersion stability and developability, it is more preferable that the structural unit represented by Formula (1) be a structural unit represented by the following Formula (1A).
From the viewpoints of dispersion stability and developability, it is more preferable that the structural unit represented by Formula (2) be a structural unit represented by the following Formula (2A).

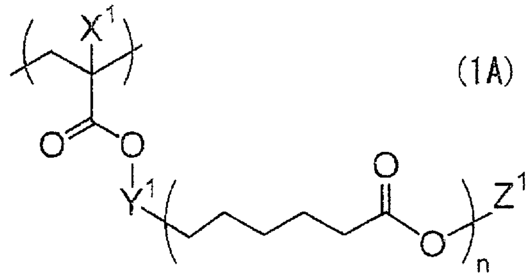

(1A)

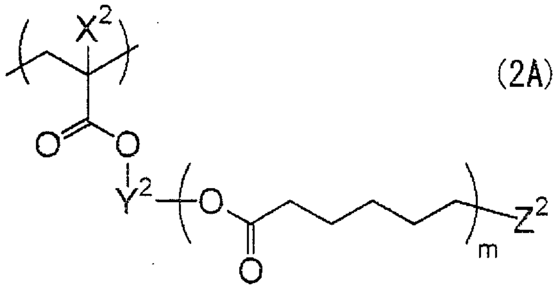

(2A)

In Formula (1A), $X^1$, $Y^1$, $Z^1$, and n respectively have the same definitions as those of $X^1$, $Y^1$, $Z^1$, and n in Formula (1), and preferable ranges thereof are also the same.
In Formula (2A), $X^2$, $Y^2$, $Z^2$, and on respectively have the same definitions as those of $X^2$, $Y^2$, $Z^2$, and m in Formula (2), and preferable ranges thereof are also the same.

The specific resin to be used in the invention contains at least one of the structural units represented by Formulae (1) to (5) in a content of preferably from 10 to 90% by mass, and more preferably from 30 to 70% by mass, with respect to the total mass of the specific resin. When the content is within the above ranges, the dispersibility of titanium black is high, and favorable development properties are obtained at the time of forming a resist. The specific resin to be used in the invention may contain two or more graft copolymers having different structures from one another.

In addition to the graft moiety, a functional group that can interact with titanium black may be introduced into the specific resin. Examples thereof include a structural unit having an acid group, a structural unit having a basic group, a structural unit having a coordinating group, and a structural unit having reactivity.

Examples of acid groups include a carboxylic group, a sulfonic group, a phosphoric group, and a phenolic hydroxyl group. A carboxylic group having good adsorbability to titanium black and high dispersibility is particularly preferable. Any one of the acid groups may be used alone, or a combination of two or more of them may be used.
It is advantageous to introduce such an acid group in that alkali development properties of the specific resin are improved.
The content of these copolymerization components to be used suitably in the specific resin of the invention is from 0.1 to 50 mol%. In particular, the content is preferably from 1 to 30 mol% from the viewpoint of suppression of decrease in image strength caused by alkaline development.

Examples of basic groups include a primary amino group, a secondary amino group, a tertiary amino group, a hetero ring having an N atom, and an amide group. A tertiary amino group having good adsorbability to pigment and high dispersibility is particularly preferable. Any one of them may be used alone, or a combination of two or more of them may be used. The content of these copolymerization components to be used suitably in the specific resin of the invention is from 0.01 to 50 mol%. In particular, the content is preferably from 0.01 to 30 mol% from the viewpoint of preventing inhibition of development properties.

Examples of coordinating groups and groups having reactivity include an acetylacetoxy group, a trialkoxysilyl group, an isocyanate group, an acid anhydride, and an acid chloride. An acetylacetoxy group having good adsorbability to pigment and high dispersibility is particularly preferable. Any one of them may be used singly, or a combination of two or more of the may be used. The content of these copolymerization components to be used suitably in the specific resin of the invention is from 0.5 to 50 mol%. In particular, the content is preferably from 1 to 30 mol% from the viewpoint of preventing inhibition of development properties.

The structure of the functional group, other than the graft moiety, which may interact with titanium black is not particularly limited as long as it has a functional group that may form an interaction with titanium black other than the graft moiety. However, it is preferable that the specific resin include at least one repeating unit obtained from a monomer represented by any one of Formulae (i) to (iii).

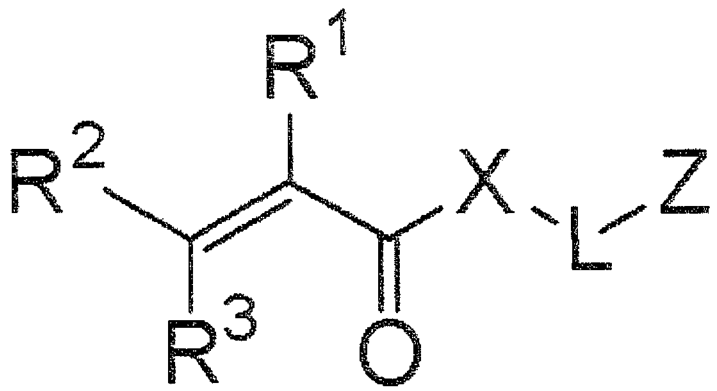

(i)

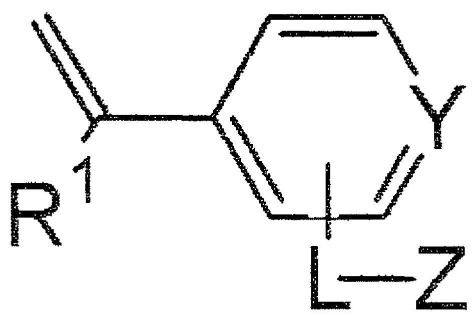

(ii)

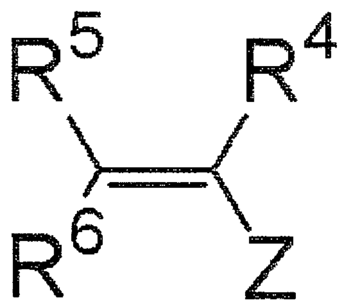

(iii)

In Formulae (i) to (iii), $R^1$, $R^2$, and $R^3$ independently represent a hydrogen atom, a halogen atom (e.g., fluorine, chlorine, and bromine) or an alkyl group having 1 to 6 carbon atoms (e.g., a methyl group, an ethyl group, and a propyl group), more preferably a hydrogen atom or an alkyl group having 1 to 3 carbon atoms, and most preferably a hydrogen atom or a methyl group. $R^2$ and $R^3$ are each particularly preferably a hydrogen atom.

X represents an oxygen atom (-O-) or an imino group (-NH-), and is preferably an oxygen atom.

L represents a single bond or a divalent linking group. Examples of divalent linking groups include divalent aliphatic groups (e.g., an alkylene group and a substituted alkylene group, an alkenylene group, a substituted alkenylene group, an alkynylene group, and a substituted alkynylene group), and divalent aromatic groups (e.g., an arylene group and a substituted arylene group), a divalent heterocyclic group, and combinations of any one of these groups and any one of an oxygen atom (-O-), a sulfur atom (-S-), an imino group (-NH-), a substituted imino group ($-NR^{31}-$, wherein $R^{31}$ represents an aliphatic group, an aromatic group, or a heterocyclic group), and a carbonyl group (-CO-).

The divalent aliphatic group may have a cyclic or branched structure. The aliphatic group is preferably an aliphatic group having 1 to 20 carbon atoms, more preferably an aliphatic group having I to 15 carbon atoms, and further preferably an aliphatic group having 1 to 10 carbon atoms. As for the aliphatic group, a saturated aliphatic group is more preferable than an unsaturated aliphatic group. Further, the aliphatic group may have a substituent. Examples of substituents include a halogen atom, a hydroxyl group, an aromatic group, and a heterocyclic group.

The divalent aromatic group is preferably a divalent aromatic group having 6 to 20 carbon atoms, more preferably a divalent aromatic group having 6 to 15 carbon atoms, and most preferably a divalent aromatic group having 6 to 10 carbon atoms. The aromatic group may have a substituent. Examples of substituents include a halogen atom, a hydroxyl group, an aliphatic group, an aromatic group, and a heterocyclic group.

The divalent heterocyclic group has preferably a five- or six-membered ring as a heterocyclic ring thereof. Other heterocyclic rings, aliphatic rings, or aromatic rings may be condensed with the heterocyclic ring included in the divalent heterocyclic group. Further, the heterocyclic group may have a substituent. Examples of substituents include a halogen atom, a hydroxy group, an oxo group (=O), a thioxo group (=S), an amino group (= NH), a substituted imino group ($=N-R^{32}$, wherein $R^{32}$ represents an aliphatic group, an aromatic group, or a heterocyclic group), an aliphatic group, an aromatic group, and a heterocyclic group.

L is preferably a single bond, an alkylene group, or a divalent linking group including an oxyalkylene structure. The oxyalkylene structure is preferably an oxyethylene structure or an oxypropylene structure. Alternatively, L may include a polyoxyalkylene structure repeatedly having two or more oxyalkylene structures therein. The polyoxyalkylene structure is preferably a polyoxyethylene structure or a polyoxypropylene structure. The polyoxyethylene structure is represented by $-(OCH_2CH_2)_n-$, wherein n represents preferably an integer of 2 or more, and more preferably an integer from 2 to 10.

In Formulae (i) to (iii), Z represents a functional group that can interact with titanium black, in addition to the graft moiety, and is preferably carboxylic acid or a tertiary amino group, and more preferably carboxylic acid. Y represents a methine group or a nitrogen atom.

In Formula (iii), $R^4$, $R^5$, and $R^6$ independently represent a hydrogen atom, a halogen atom (e.g., fluorine, chlorine, and bromine), an alkyl group having I to 6 carbon atoms (e.g., a methyl group, an ethyl group, and a propyl group), Z, or -L-Z, wherein L and Z have the same definitions as L and Z described above, respectively. $R^4$, $R^3$, and $R^6$ are each preferably a hydrogen atom or an alkyl group having I to 3 carbon atoms, and more preferably a hydrogen atom.

In the invention, as a monomer represented by Formula (i) above, it is preferable to use a compound in which $R^1$, $R^2$, and $R^3$ each represent a hydrogen atom or a methyl group, L represents an alkylene group or a divalent linking group including an oxyalkylene structure, X represents an oxygen atom or an imino group, and Z represents carboxylic acid.

As a monomer represented by Formula (ii) above, it is preferable to use a compound in which $R^1$ represents a hydrogen atom or a methyl group, L represents an alkylene group, Z represents carboxylic acid, and Y represents a methine group.

As a monomer represented by Formula (iii), it is preferable to use a compound in which $R^4$, $R^5$, and $R^6$ each represent a hydrogen atom or a methyl group, L represents a single bond or an alkylene group, and Z represents carboxylic acid.

Hereinafter, examples of representative compounds represented by Formulae (i) to (iii) will be described.

Specifically, examples thereof include: methacrylic acid; crotonic acid; isocrotonic acid; a reaction product of a compound having an addition-polymerizable double bond and a hydroxyl group in the molecule (e.g., 2-hydroxyethyl methacrylate) and a succinic anhydride; a reaction product of a compound having an addition-polymerizable double bond and a hydroxyl group in the molecule and a phthalic anhydride; a reaction product of a compound having an addition-polymerizable double bond and a hydroxyl group in the molecule and a tetrahydroxyphthalic anhydride; a reaction product of a compound having an addition-polymerizable double bond and a hydroxyl group in the molecule and a trimellitic anhydride; a reaction product of a compound having an addition-polymerizable double bond and a hydroxyl group in the molecule and a pyromellitic anhydride; acrylic acid; acrylic acid dimer; acrylic acid oligomer; maleic acid; itaconic acid; fumaric acid; 4-vinylbenzoic acid; vinylphenol; and 4-hydroxyphenyl methacrylamide.

The content of the functional group that can interact with titanium black, such as a monomer having an acidic group, in the specific resin is preferably from 0.05 to 90% by mass, more preferably from 1.0 to 80% by mass, and further preferably from 10 to 70% by mass based, with respect to the specific resin from the viewpoint of interaction with titanium black, dispersion stability, and permeability to developer.

For the purpose of improving various performances such as image strength, the specific resin to be included in the titanium black dispersion composition according to the invention may further contain other structural units having

various functions (such as a structural unit having a functional group which has an affinity to a dispersion medium which is used for a dispersion product) as a copolymerization component, in addition to the structural unit having a graft moiety and the functional group that can interact with titanium black, unless the effects of the invention are impaired.

Examples of the copolymerization component which may be used in the specific resin according to the invention include radical polymerizable compounds selected from acrylic acid esters, methacrylic acid esters, styrenes, acrylonitriles, and methacrylonitriles.

Any one of the copolymerization components may be used singly, or a combination of two or more of them may be used. The content of copolymerization components suitably used in the specific resin is from 0 to 90 mol%, and particularly preferably from 0 to 60 mol%. When the content is within the ranges above, sufficient pattern formation is carried out.

Examples of solvents to be used in the synthesis of the specific resin include ethylene dichloride, cyclohexanone, methyl ethyl ketone, acetone, methanol, ethanol, propanol, butanol, ethylene glycol monomethyl ether, ethylene glycol monoethyl ether, 2-methoxyethylacetate, 1-methoxy-2-propanol, 1-methoxy-2-propyl acetate, N,N-dimethylformamide, N,N-dimethylacetamide, dimethyl sulfoxide, toluene, ethyl acetate, methyl lactate, and ethyl lactate. Any one of these solvents may be used singly, or a mixture of two or more thereof may be used.

Specific examples of the specific resin include Exemplary Compounds 1 to 53 shown below. In this regard, the figures added to each structural unit (the main chain part) indicate percent by mass.

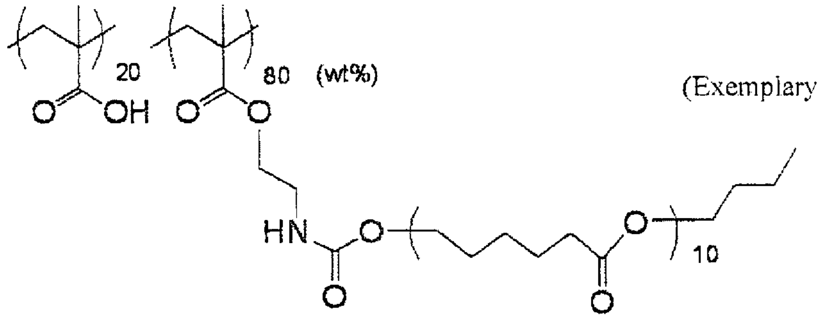

(Exemplary Compound 1)

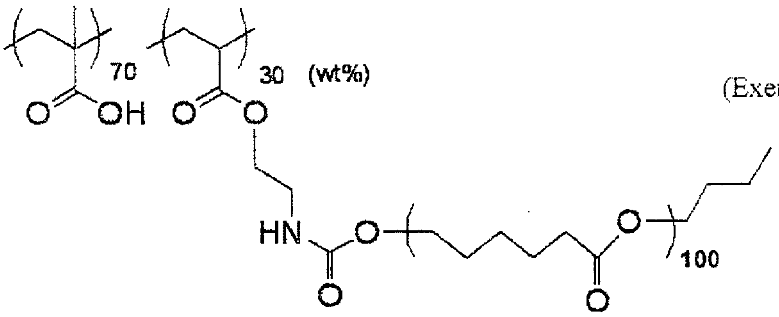

(Exemplary Compound 2)

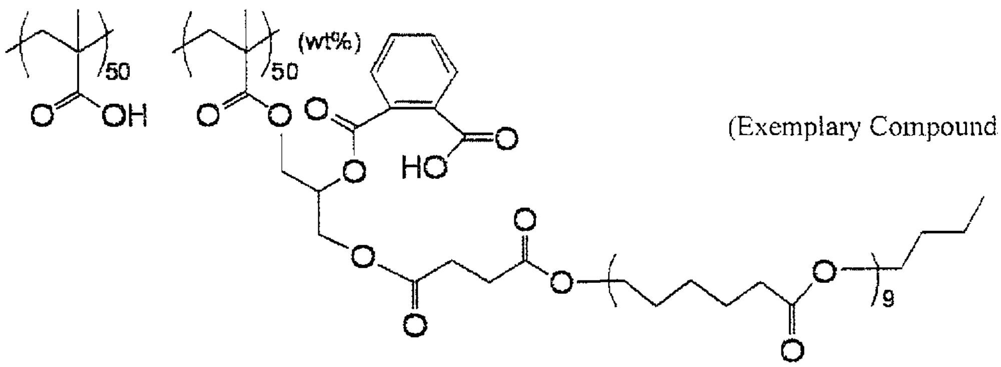

(Exemplary Compound 3)

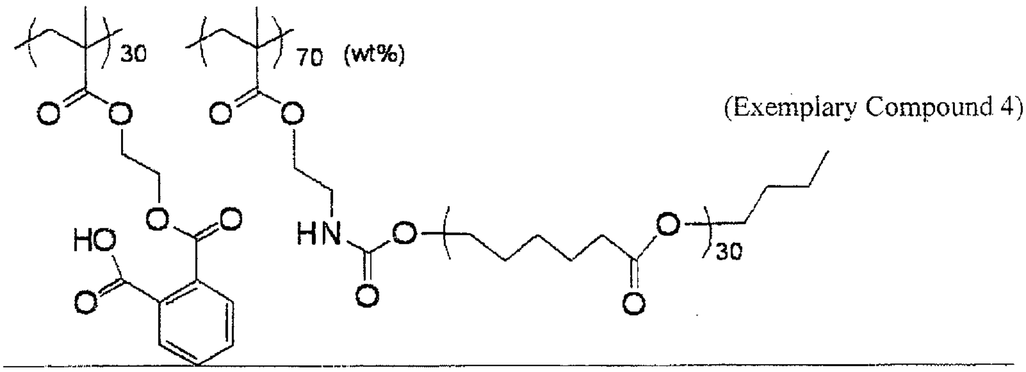

(Exemplary Compound 4)

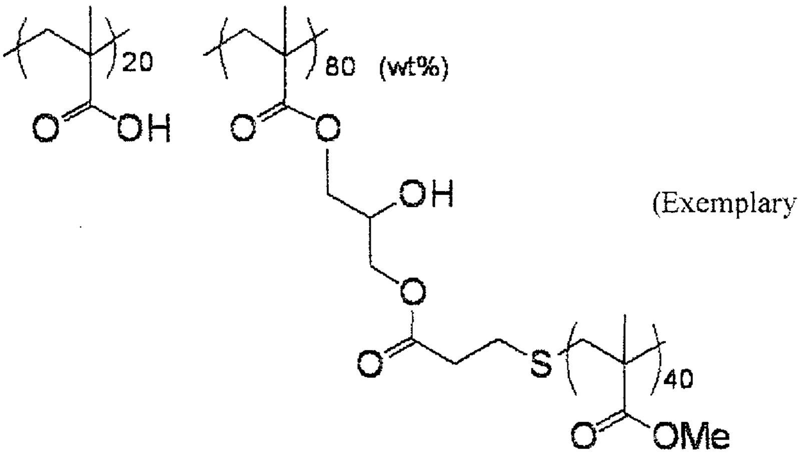

(Exemplary Compound 5)

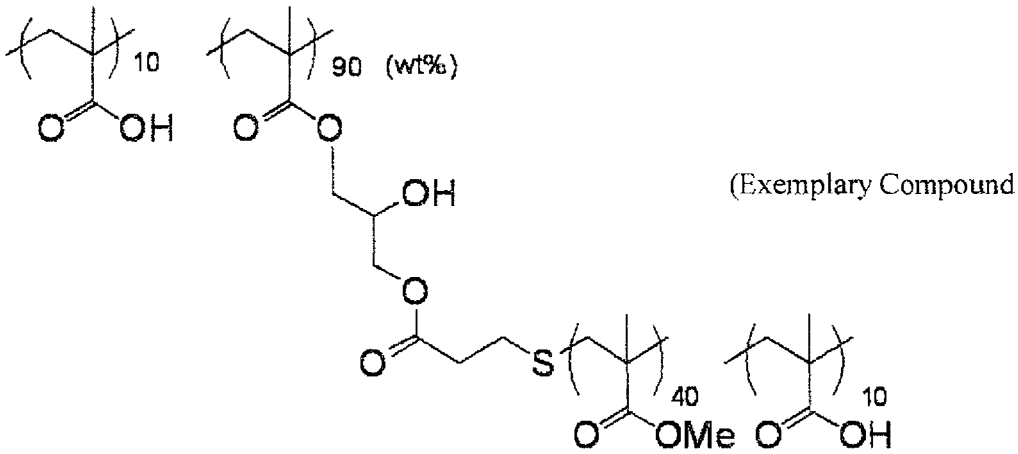

(Exemplary Compound 6)

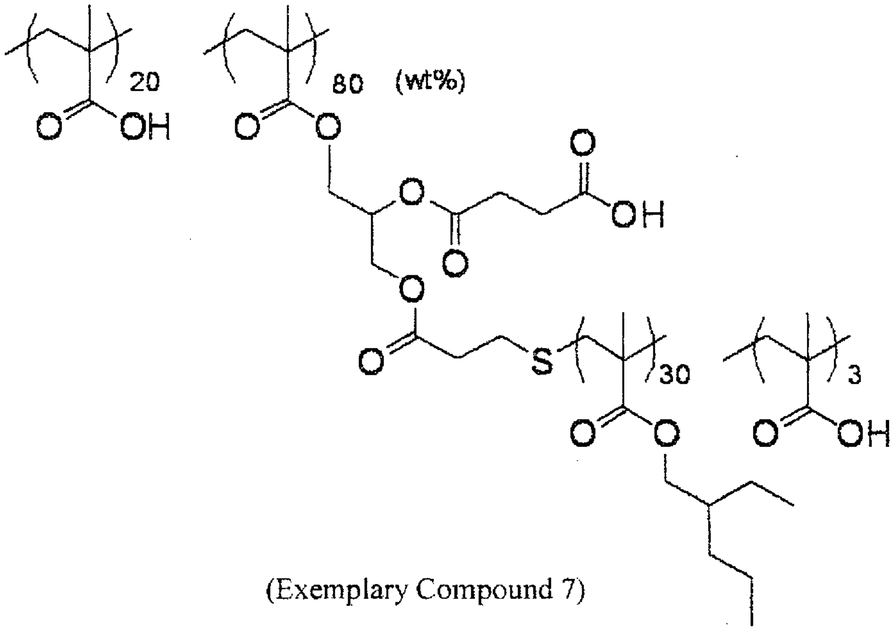

(Exemplary Compound 7)

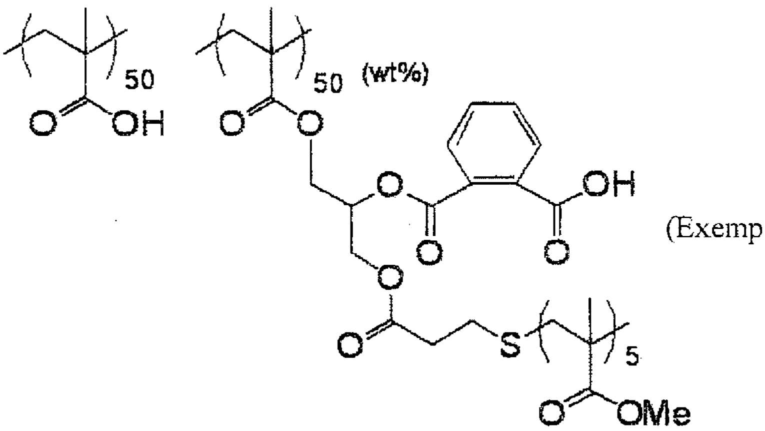

(Exemplary Compound 8)

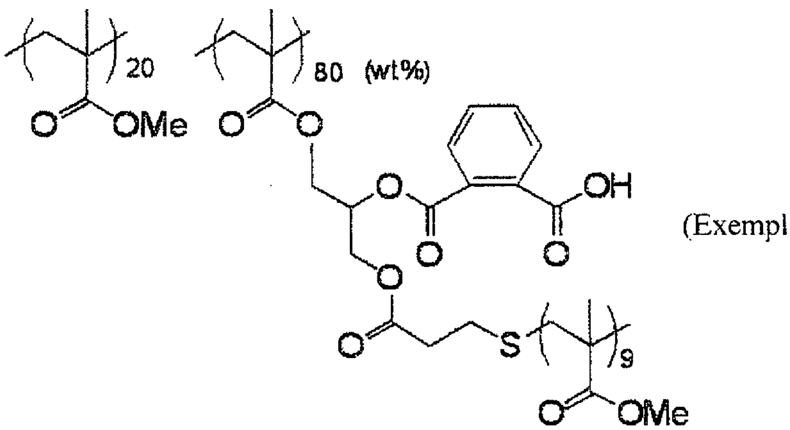

(Exemplary Compound 9)

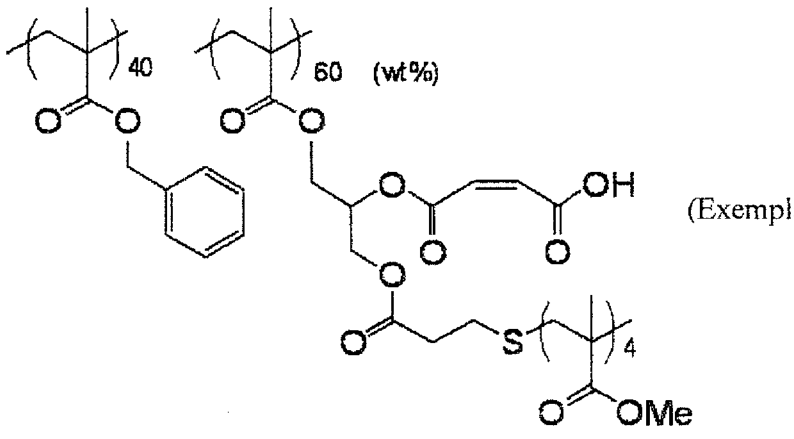

(Exemplary Compound 10)

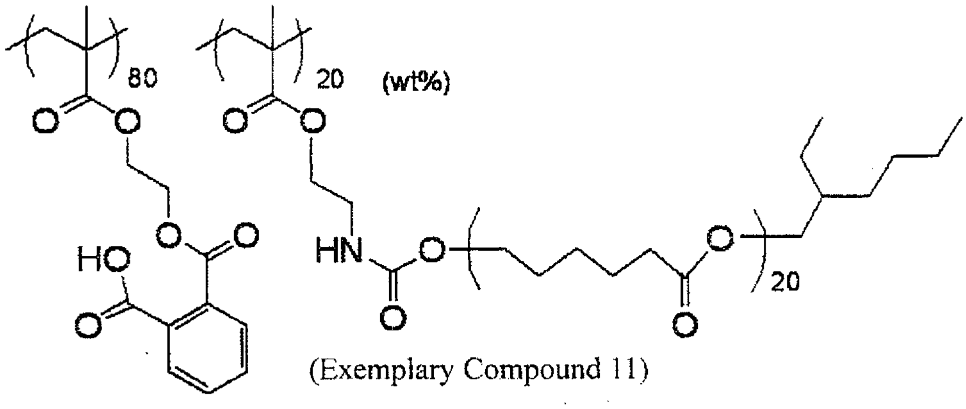

(Exemplary Compound 11)

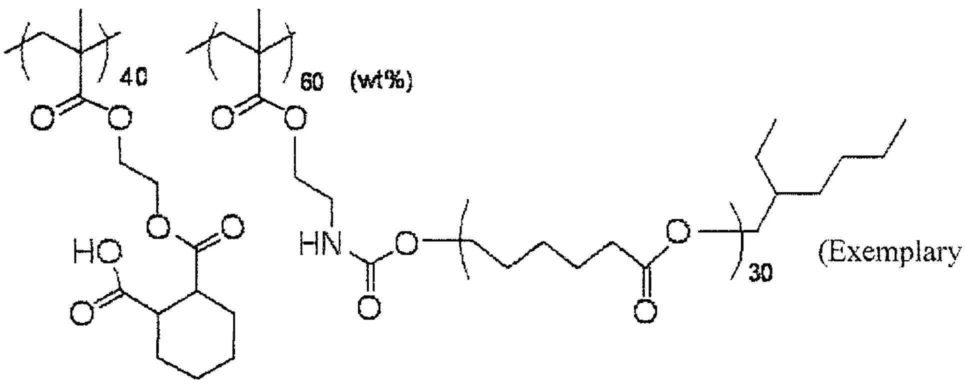

(Exemplary Compound 12)

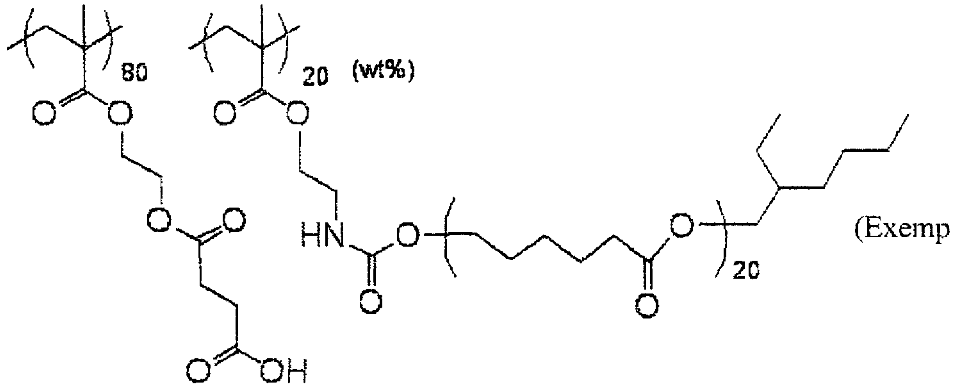

(Exemplary Compound 13)

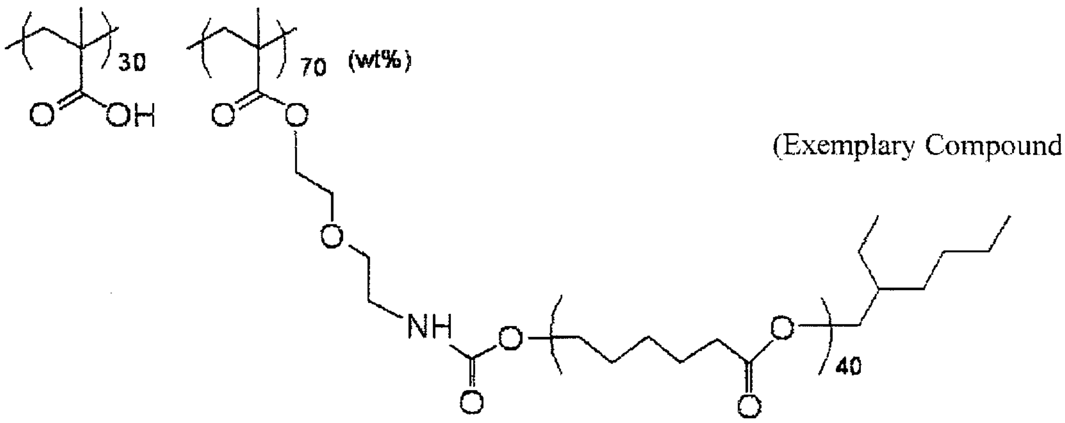

(Exemplary Compound 14)

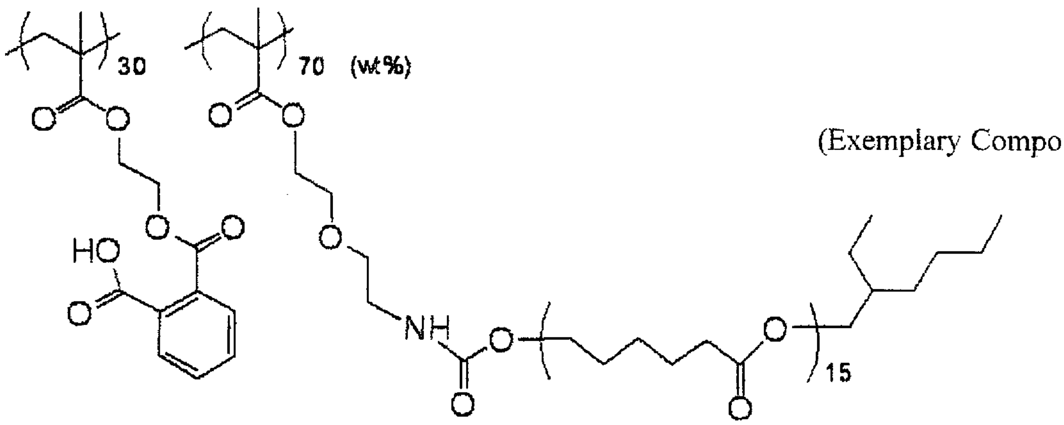

(Exemplary Compound 15)

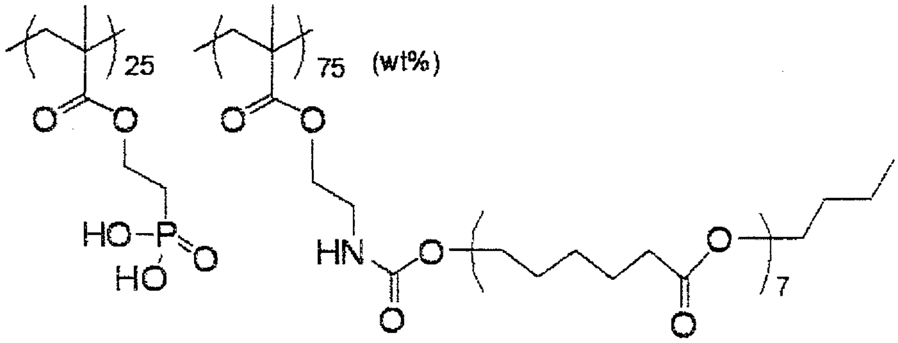

(Exemplary Compound 16)

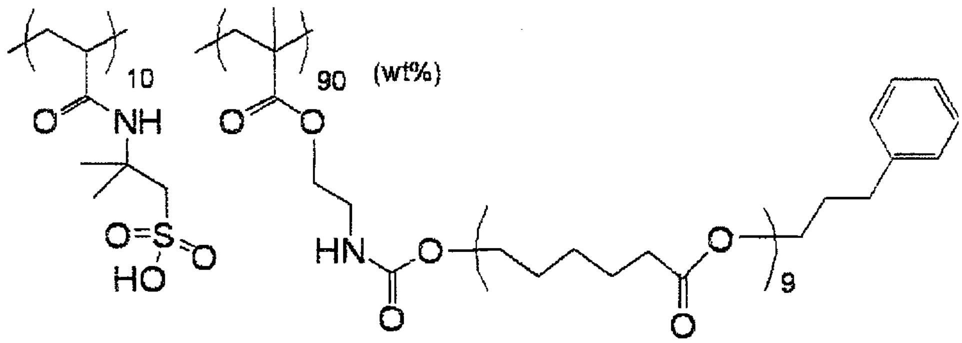

(Exemplary Compound 17)

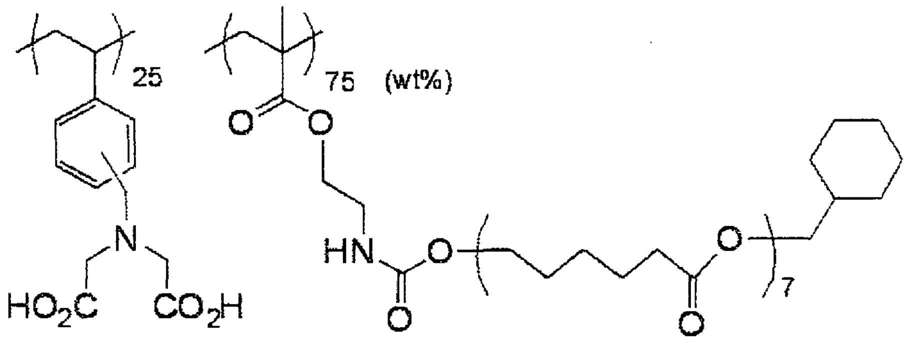

(Exemplary Compound 18)

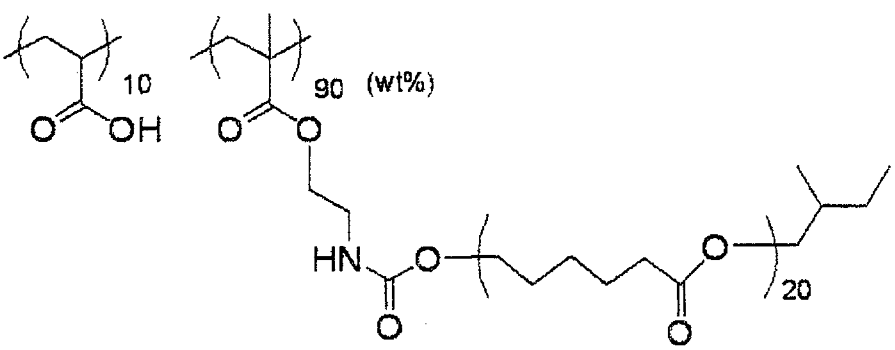

(Exemplary Compound 19)

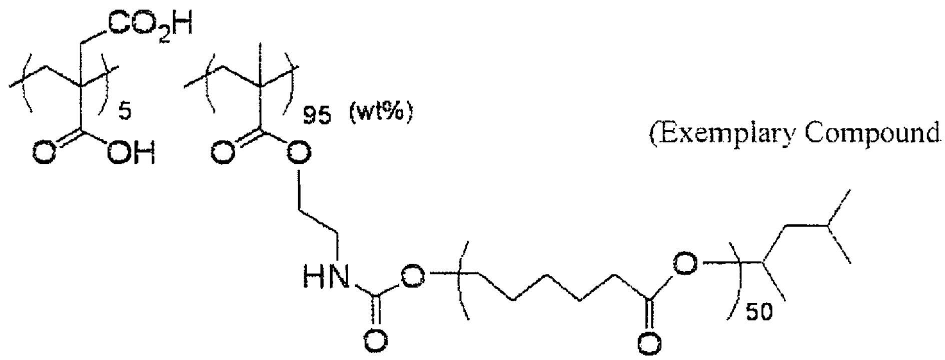

(Exemplary Compound 20)

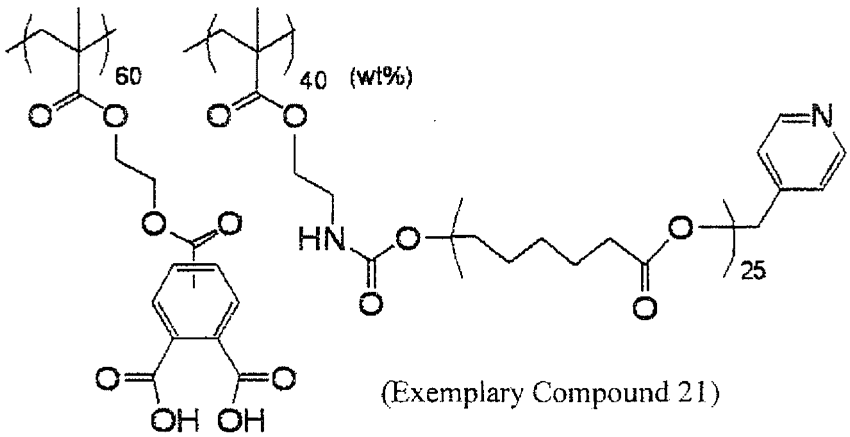

(Exemplary Compound 21)

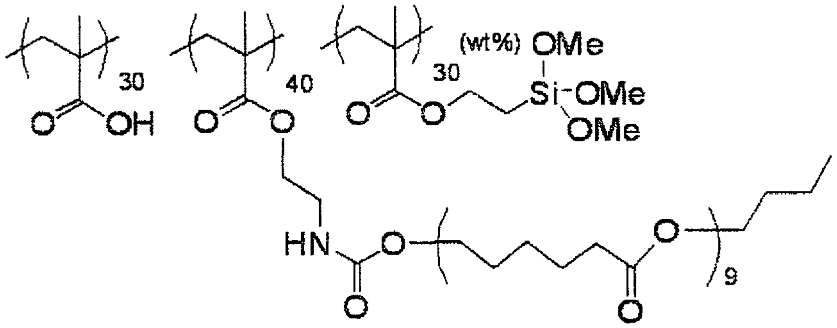

(Exemplary Compound 22)

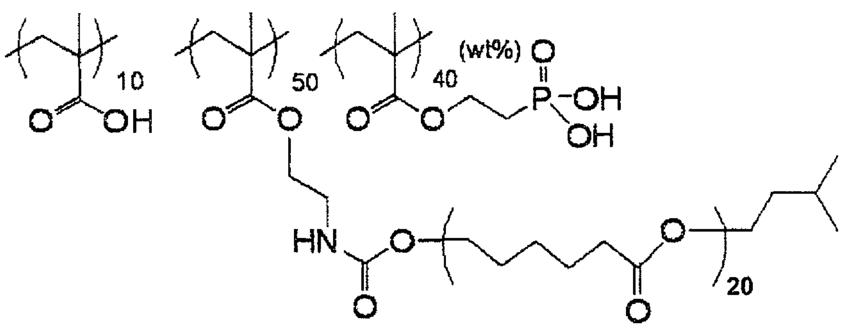

(Exemplary Compound 23)

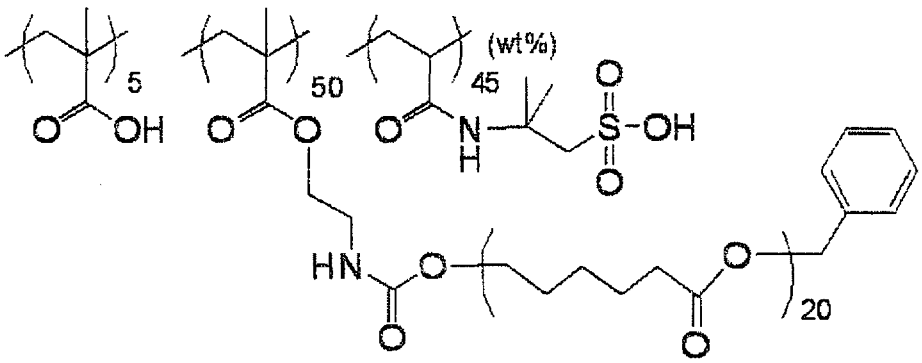

(Exemplary Compound 24)

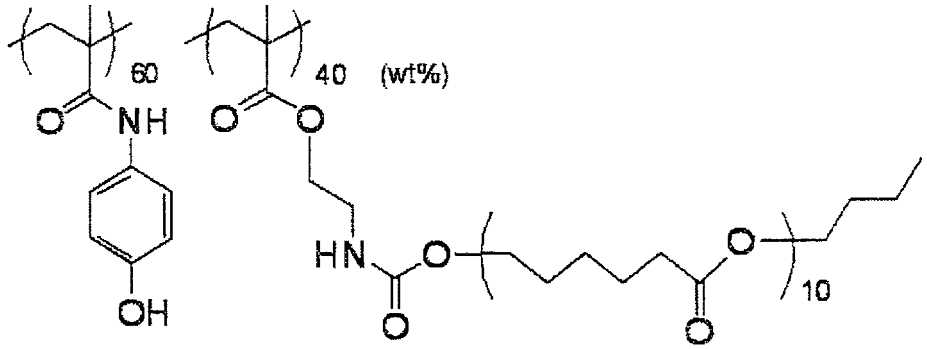

(Exemplary Compound 25)

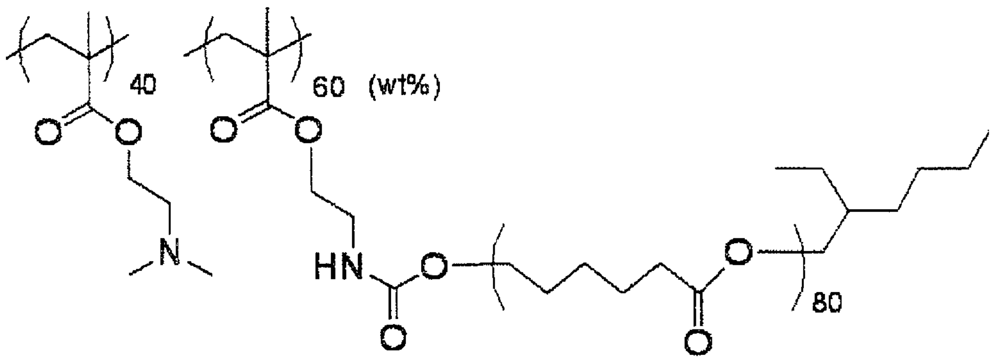

(Exemplary Compound 26)

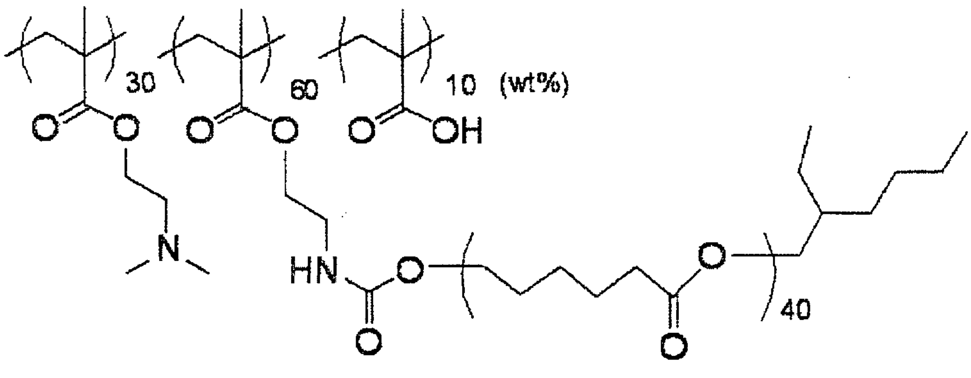

(Exemplary Compound 27)

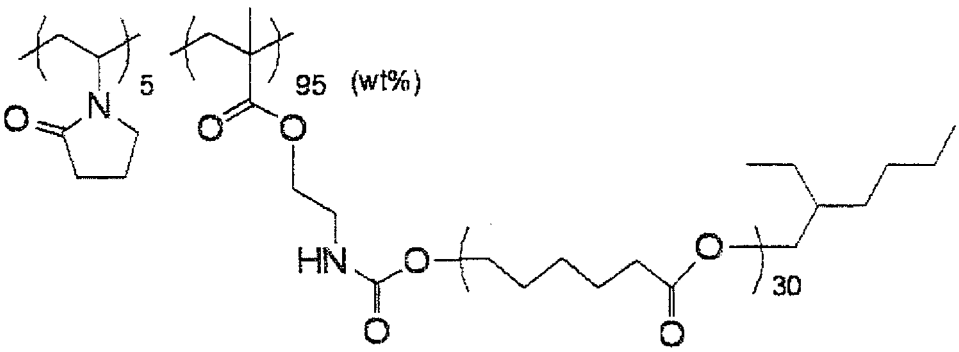

(Exemplary Compound 28)

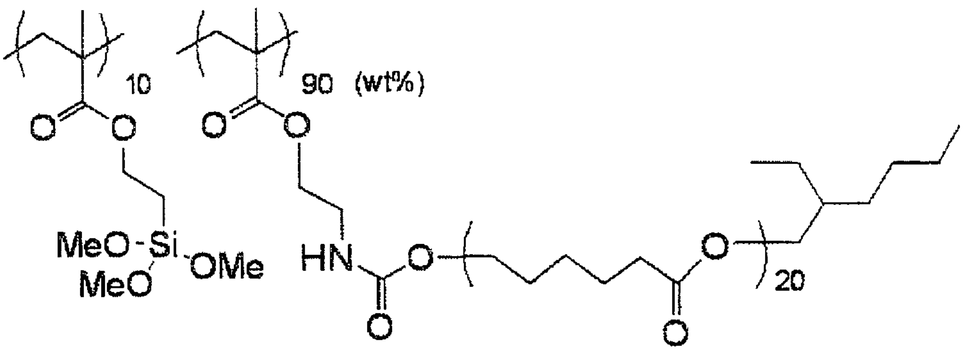

(Exemplary Compound 29)

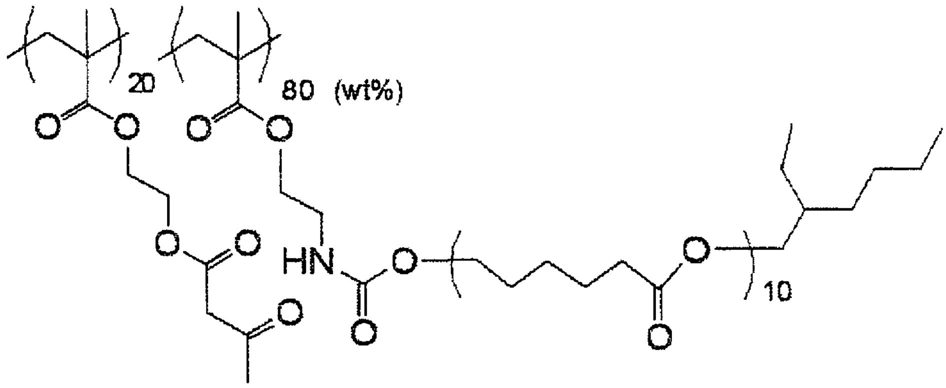

(Exemplary Compound 30)

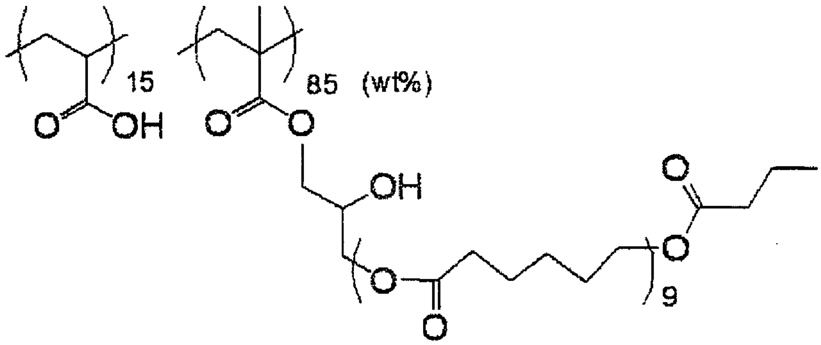

(Exemplary Compound 31)

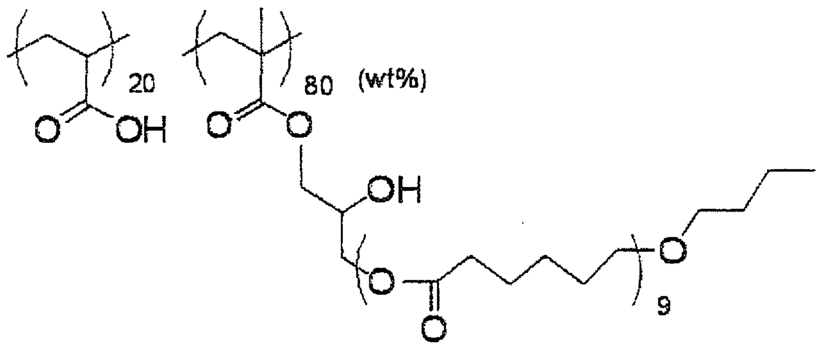

(Exemplary Compound 32)

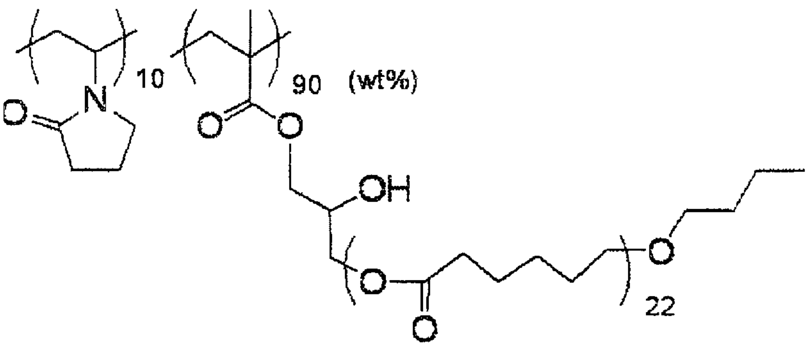

(Exemplary Compound 33)

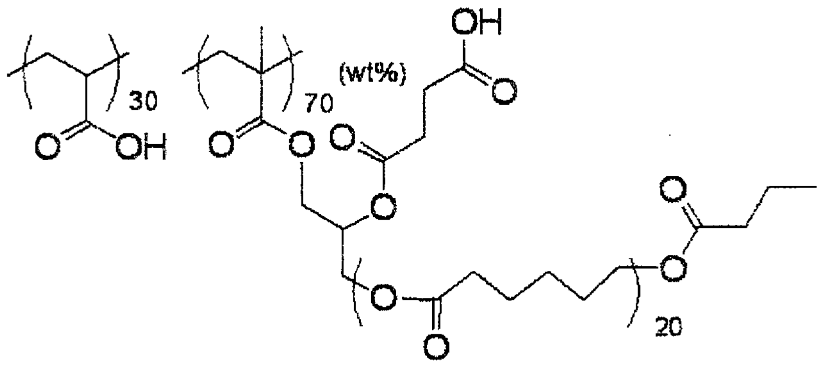

(Exemplary Compound 34)

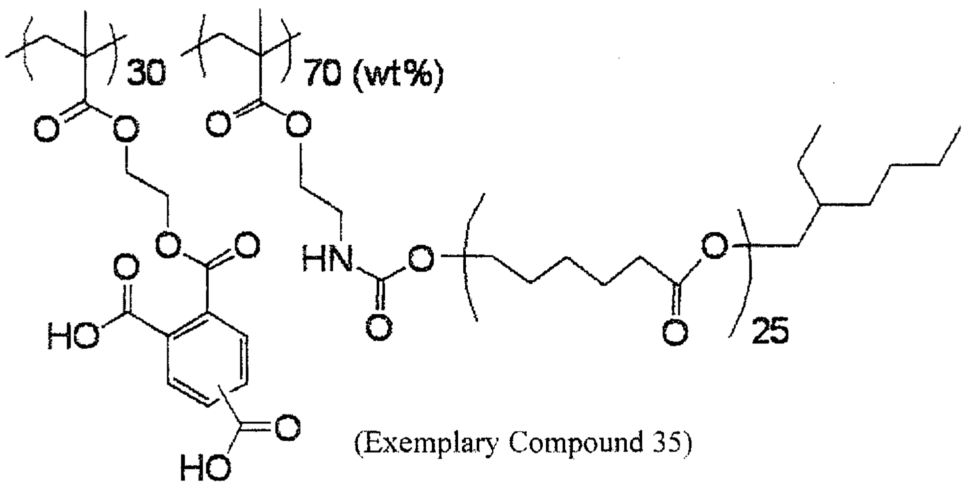

(Exemplary Compound 35)

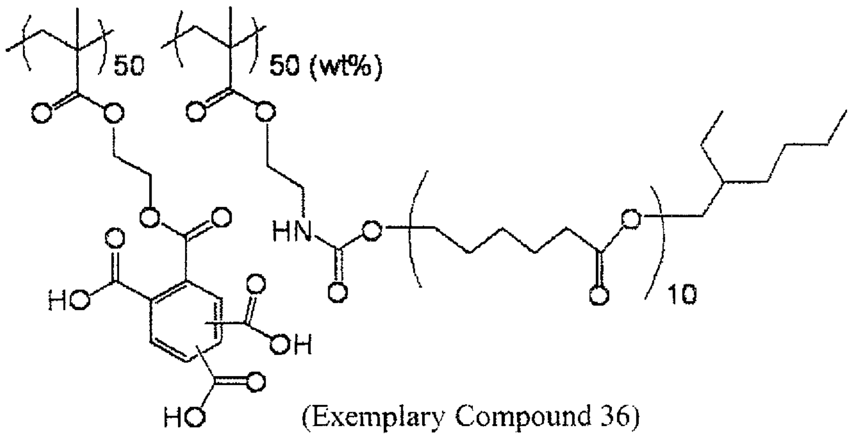

(Exemplary Compound 36)

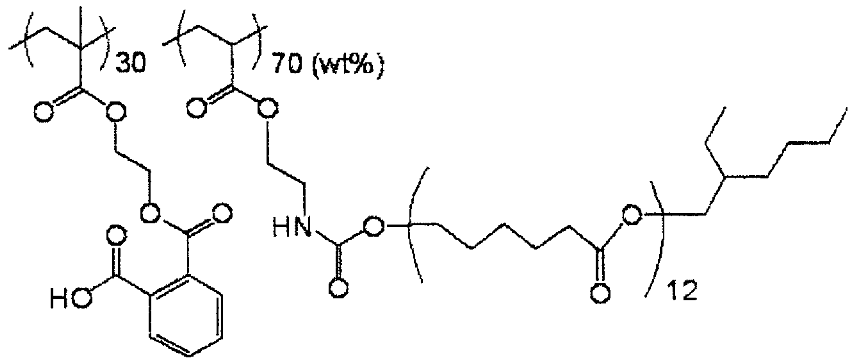

(Exemplary Compound 37)

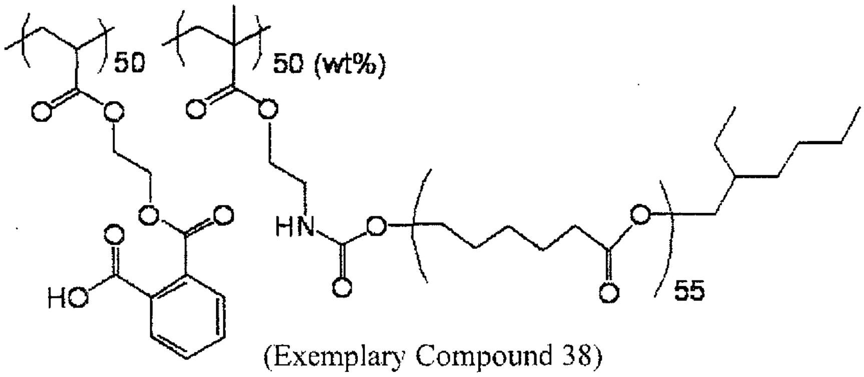

(Exemplary Compound 38)

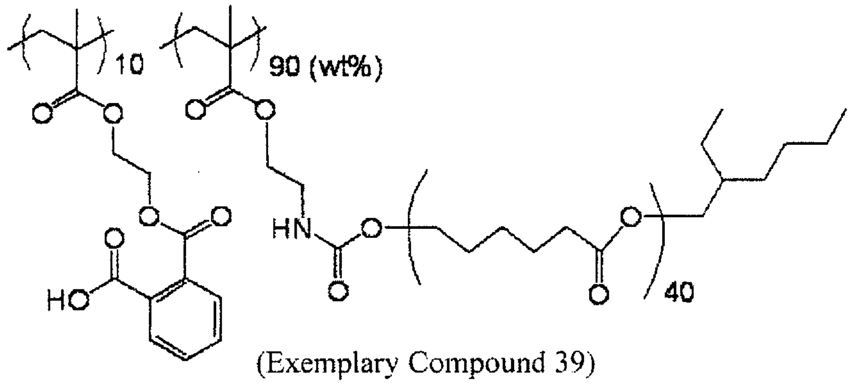

(Exemplary Compound 39)

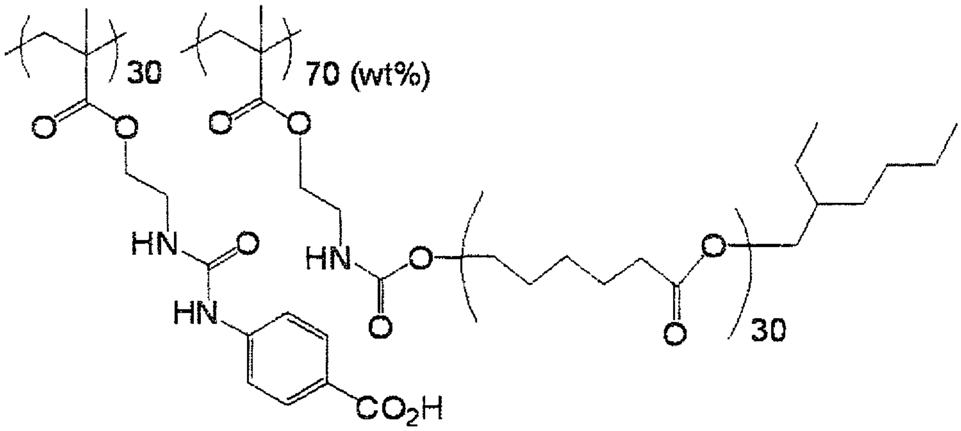

(Exemplary Compound 40)

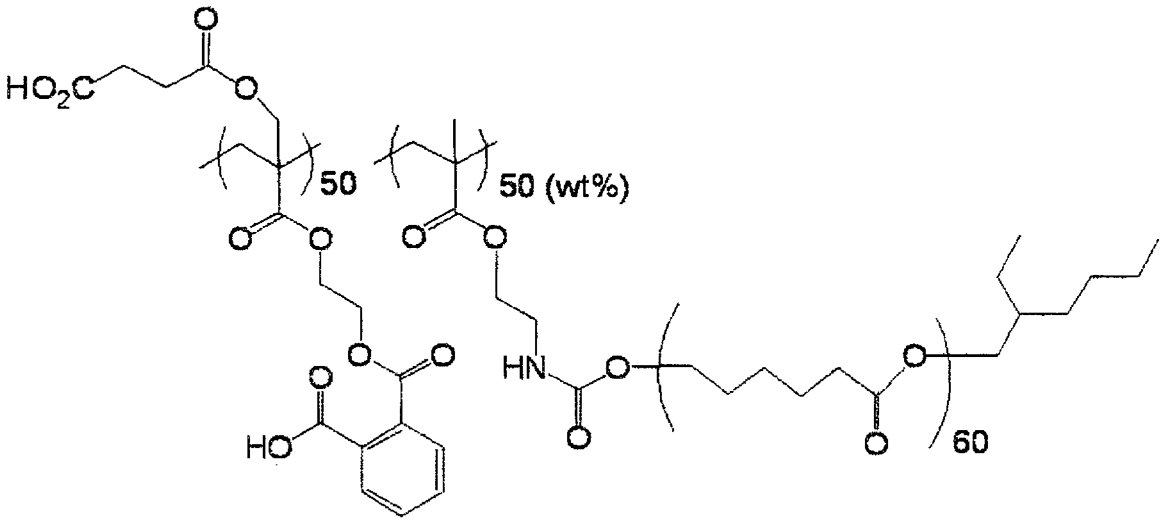

(Exemplary Compound 41)

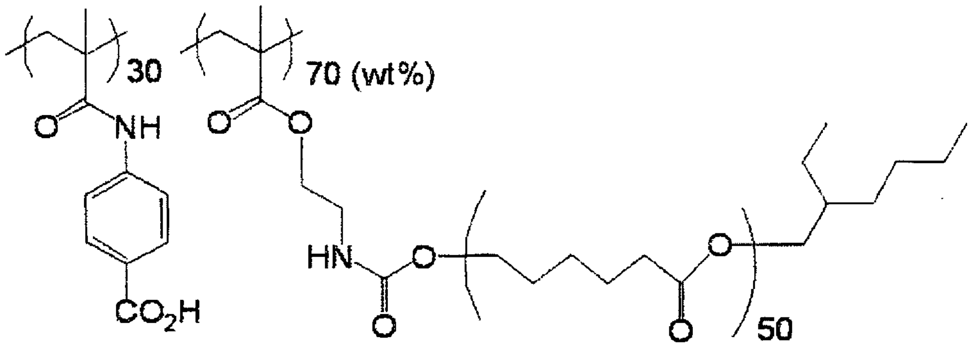

(Exemplary Compound 42)

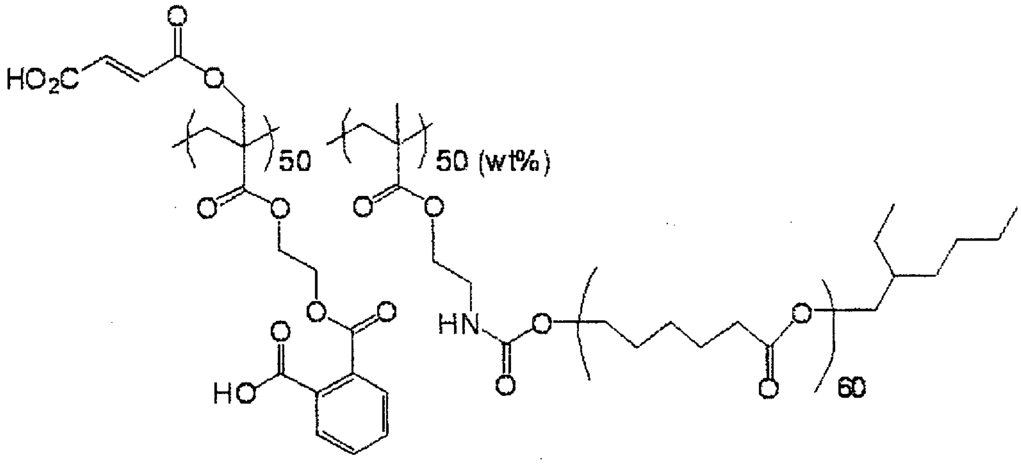

(Exemplary Compound 43)

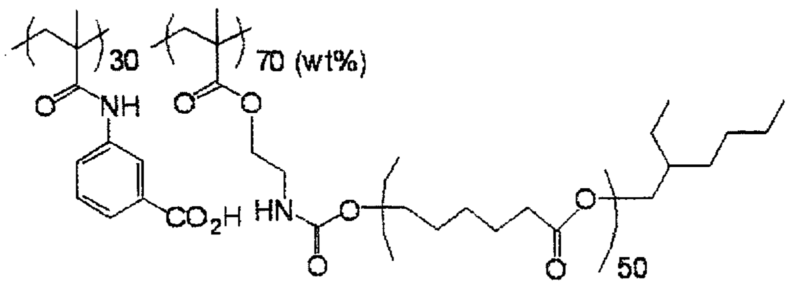

(Exemplary Compound 44)

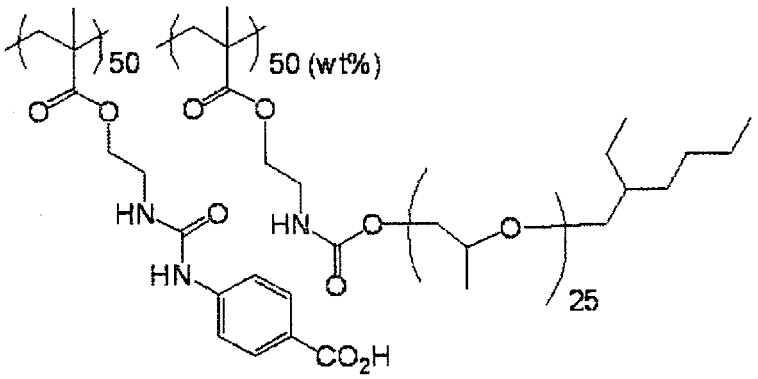

(Exemplary Compound 45)

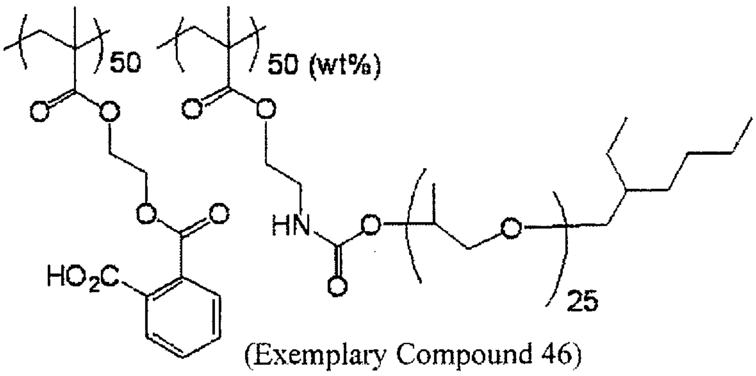

(Exemplary Compound 46)

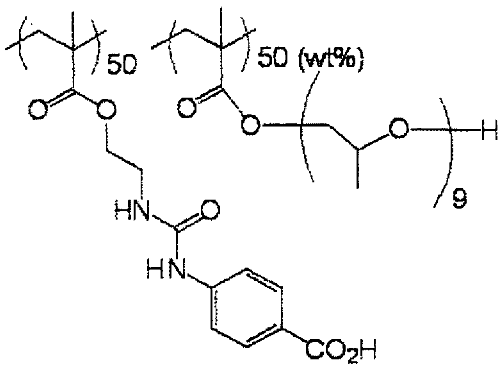

(Exemplary Compound 47)

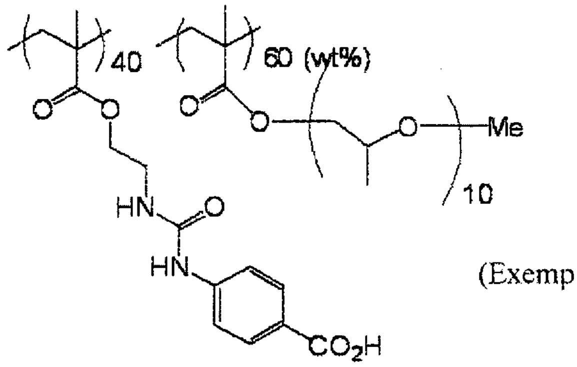

(Exemplary Compound 48)

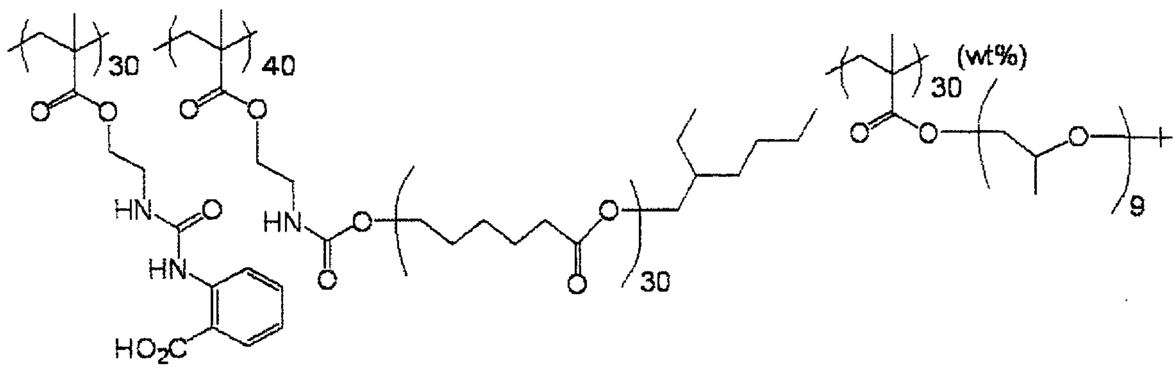

(Exemplary Compound 49)

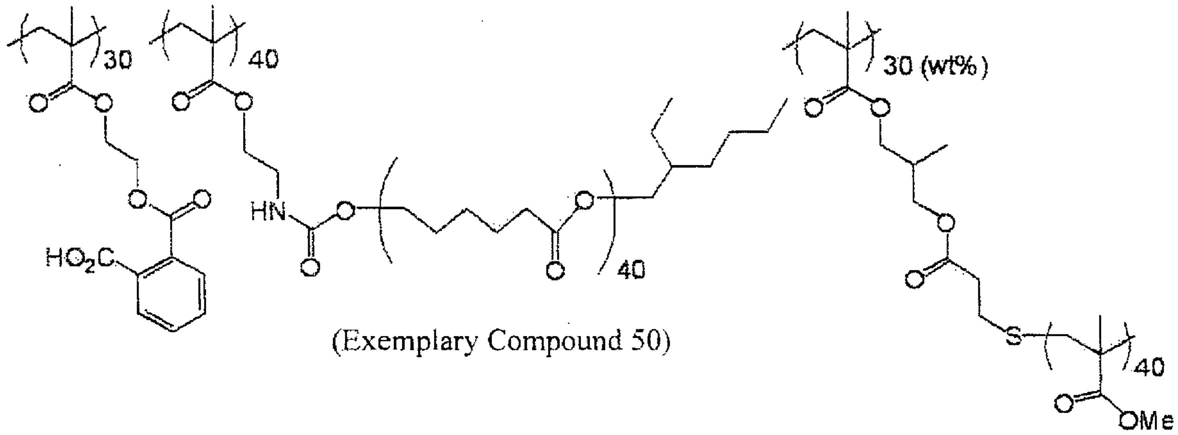

(Exemplary Compound 50)

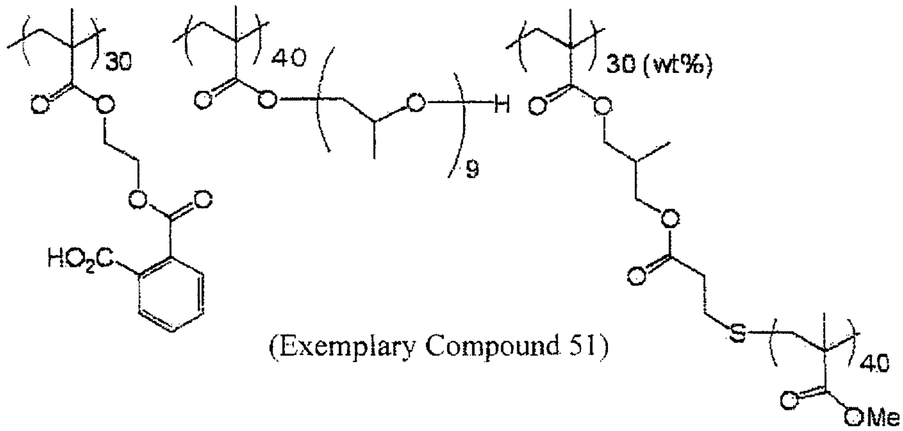

(Exemplary Compound 51)

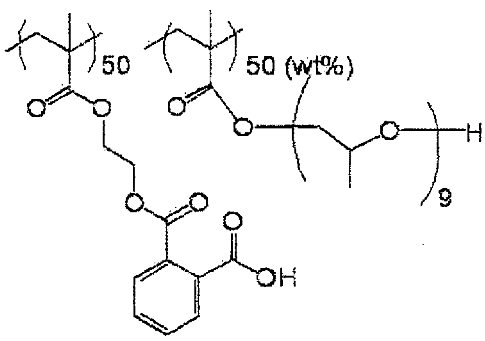

(Exemplary Compound 52)

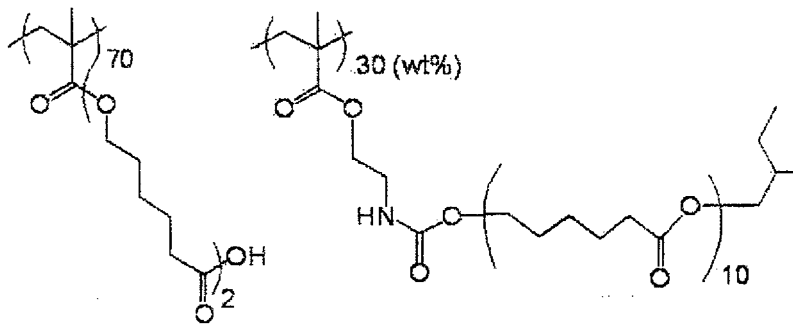

(Exemplary Compound 53)

In addition to the components described above, the dispersion composition of the invention may further contain components of the photosensitive resin composition which will be described hereinafter (e.g., a resin, a photopolymerization initiator, and a polymerizable compound). That is, a photosensitive resin composition may be produced in the process of producing the dispersion composition.

*Photosensitive resin composition for light-shielding color filter and method of producing the same*

The method of producing a photosensitive resin composition for a light-shielding color filter (hereinafter, which may be simply referred to as "photosensitive resin composition") of the invention includes: a first dispersion process in which a mixed liquid containing at least titanium black, a dispersant, the solvent 1, and the solvent 2 is subjected to a dispersion treatment without using a medium, wherein the content of the solvent 2 is 5% by mass or more with respect to the total content of the solvents 1 and 2; and a second dispersion process in which the dispersion liquid obtained by the first dispersion process is subjected to an additional dispersion treatment using a medium, in a process of producing a photosensitive resin composition for a light-shielding color filter containing titanium black, a dispersant, a resin, a polymerizable compound, a photopolymerization initiator, the solvent 1, and the solvent 2.
Further, the photosensitive resin composition for a light-shielding color filter of the invention is one produced by the method of producing a photosensitive resin composition for a light-shielding color filter of the invention.
According to the photosensitive resin composition of the invention and the method of producing the same, precipitation of titanium black is prevented, and the dispersion stability is dramatically improved.
Further, the leakage in light shielding caused by the coated surface abnormalities when the dispersion composition is made into a coating film is suppressed.
In the method of producing a photosensitive resin composition of the invention, the timing at which each component is added is not particularly limited as long as the dispersion treatments in the first and second dispersion processes are performed in the process of producing a photosensitive resin composition which contains at least titanium black, a dispersant, a resin (a resin other than the dispersant), a polymerizable compound, a photopolymerization initiator, and solvents (the solvents 1 and 2).
For example, a photosensitive resin composition may be made by producing a dispersion composition by the method of producing a dispersion composition of the invention, which is described above, and adding components such as a resin, a polymerizable compound, and a photopolymerization initiator (and a solvent, if necessary) to the produced dispersion composition.
Alternatively, in the method of producing a dispersion composition of the invention, at least one of a resin, a polymerizable compound, and a photopolymerization initiator is added in advance and the rest of the components such as a photosensitive resin composition may be added to the produced dispersion composition.
Alternatively, in the method of producing a dispersion composition of the invention, all of the resin, polymerizable compound, and photopolymerization initiator are added to produce a photosensitive resin composition as a dispersion composition.
Among the components of the photosensitive resin composition of the invention, titanium black, the dispersant, and the solvents 1 and 2 are as described in the section "Dispersion composition and method for producing the same", and preferable ranges thereof are also the same as those described therein.
Hereinafter, the resin, polymerizable compounds, photopolymerization initiators, and other components included in the photosensitive resin composition of the invention will be described in detail.

*Resin*

The photosensitive resin composition of the invention includes a resin (i.e., a resin other than the dispersant).

It is preferable to use a linear organic polymer as the resin. As such a linear organic polymer, any one of known linear organic polymers may be arbitrarily used. It is preferable to select a linear organic polymer soluble or swellable in water or weak alkali water in order to make water development or weak alkali water development possible.

The linear organic polymer is selected according to the application not only as a coat forming material but also as a developing material in water, weak alkali water, or organic solvent. For example, the use of a water-soluble organic polymer enables water development.

Examples of linear organic polymers include radical polymers having a carboxylic group in the side chain, for example, polymers described in JP-A No. 59-44615, JP-B Nos. 54-34327, 58-12577, 54-25957, JP-ANos. 54-92723, 59-53836, and 59-71048, namely resins obtained by homopolymerizing or copolymerizing a carboxyl group-containing monomer; resins obtained by homopolymerizing or copolymerizing an acid anhydride-containing monomer and then hydrolyzing, half-esterifying or half-amidating the acid anhydride unit; and epoxy acrylates obtained by modifying an epoxy resin with an unsaturated monocarboxylic acid and an acid anhydride. Examples of monomers having a carboxyl group (i.e., carboxyl group-containing monomer) include acrylic acid, methacrylic acid, itaconic acid, crotonic acid, maleic acid, fumaric acid, and 4-carboxylstyrene. Examples of monomers having an acid anhydride (i.e., acid anhydride-containing monomer) include a maleic anhydride. Similarly, a cellulose derivative having a carboxylic group in the side chain may be used. In addition to these, those obtained by adding a cyclic anhydride to a polymer having a hydroxyl group are useful. Among the linear organic polymers, the linear organic polymer soluble or swellable in water or weak alkali water may be hereinafter referred to as "alkali soluble resin".

Among them, a (meth)acrylic resin having an allyl group, a vinyl ester group, or the like and a carboxyl group in the side chain, an alkali-soluble resin having a double bond in the side chain described in JP-A No. 2000-187322 or JP-A No. 2002-62698, and an alkali-soluble resin having an amide group in the side chain described in JP-A No. 2001-242612 are suitable in view of excellent balance between film strength, sensitivity, and development properties. Urethane binder polymers containing an acid group described in JP-B No. 7-12004, 7-120041, 7-120042, or 8-12424, JP-A No. 63-287944, 63-287947, or 1-271741, and a urethane binder polymer having an acid group and a double bond in the side chain described in JP-A No. 2002-107918 are excellent in strength, and thus they are advantageous in respect of the print durability and low-light exposure adequacy. Further, acetal-modified polyvinyl alcohol binder polymers having an acid group described in European Patent Application No. 993966 or 1204000 or JP-A No. 2001-318463 are suitable in respect of excellent balance in film strength and development properties. Furthermore, polyvinyl pyrrolidone and polyethylene oxide are useful as a water-soluble linear organic polymer. In order to increase the strength of a cured film, alcohol-soluble nylon and a polyether of 2,2-bis-(4-hydroxyphenyl)-propane and epichlorohydrin are useful.

Among the resins, a resin having a polymerizable group is preferable; a resin having a group containing a double bond as the polymerizable group is more preferable; and a resin having an acryloyl group or a methacryloyl group is further preferable. The resin may be any of a random polymer, a block polymer, and a graft polymer.

The weight average molecular weight of the resin is preferably 5,000 or more, and further preferably in the range of from 10,000 to 300,000. The number average molecular weight thereof is preferably 1,000 or more, further preferably in the range of from 2,000 to 250,000. The degree of polydispersion (i.e., weight average molecular weight/ number average molecular weight) is preferably I or more, and further preferably in the range of from 1.1 to 10.

Only one species of the resin may be used singly, or a combination of two or more species thereof may be used. The content of the resin in the total solid content of the photosensitive resin composition (which means the total content in the case in which two or more species of resins are used) is not particularly limited, and it is preferably from 5 to 50% by mass, more preferably from 10 to 40% by mass, and particularly preferably from 10 to 35% by mass, from the viewpoint of more effectively obtaining the effects of the invention.

*Polymerizable compound*

The photosensitive resin composition of the invention includes at least one polymerizable compound.

Examples of polymerizable compounds include an addition-polymerizable compound having at least one ethylenic unsaturated double bond. Specifically, the polymerizable compound is selected from the compounds having at least one, preferably two or more, terminal ethylenic unsaturated bond(s). Such compounds are widely known in the field of industry, and any of them may be used in the invention without particular limitation. These compounds may have any of chemical forms such as monomer, prepolymer, namely, dimer, trimer or oligomer, and a mixture or (co)polymer thereof.

Examples of monomers and (co)polymers thereof include unsaturated carboxylic acids (such as acrylic acid, methacrylic acid, itaconic acid, crotonic acid, isocrotonic acid, and maleic acid), and esters and amides thereof, and copolymers thereof. Preferable examples thereof include esters of an unsaturated carboxylic acid and an aliphatic polyalcohol compound, amides of an unsaturated carboxylic acid and an aliphatic polyamine compound, and (co)polymers thereof. Additionally, reaction products obtained from unsaturated carboxylic acid esters or amides having a nucleophilic substituent group such as a hydroxyl group, an amino group, or a mercapto group and monofunctional or polyfunctional isocyanates or epoxies; and dehydration condensation reaction products of unsaturated carboxylic acid esters or amides

having a nucleophilic substituent group such as a hydroxyl group, an amino group, or a mercapto group and monofunctional or polyfunctional carboxylic acids are suitably used. Further, addition reaction products of unsaturated carboxylic acid esters or amides having an electrophilic substituent group such as an isocyanate group or an epoxy group and monofunctional or polyfunctional alcohols, amines, or thiols; and substitution reaction products of unsaturated carboxylic acid esters or amides having a leaving substituent such as a halogen group or a tosyloxy group and monofunctional or polyfunctional alcohols, amines or thiols are also suitable. Alternatively, as another example, compounds obtained by replacing the unsaturated carboxylic acid with an unsaturated phosphonic acid, styrene, or vinyl ether may be used.

Specific examples of monomers of the esters of an aliphatic polyhydric alcohol compound and an unsaturated carboxylic acid include: acrylic acid esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylol propane triacrylate, trimethylol propane tri(acryloyloxypropyl)ether, trimethylol ethane triacrylate, hexanediol diacrylate, 1.4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, polyester acrylate oligomer and isocyanuric acid EO-modified triacrylate; methacrylic acid esters such as tetramethylene glycol dimethacrylate, triethylene glycol dimethacrylate, neopentyl glycol dimethacrylate, trimethylolpropane trimethacryiate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy) phenyl]dimethylmethane, and bis-[p-(methacryloxyethoxy)phenyl]dimethylmethane; itaconic acid esters such as ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate; crotonic acid esters such as ethylene glycol dicrotonate, tetramethylene glycol dicrotonate, pentaerythritol dicrotonate, and sorbitol tetradicrotonate; isocrotonic acid esters such as ethylene glycol diisocrotonate, pentaerythritol diisocrotonate, and sorbitol tetraisocrotonate; maleic acid esters such as ethylene glycol dimaleate, triethylene glycol dimaleate, pentaerythritol dimaleate, and sorbitol tetramaleate. Examples of other esters to be suitably used include aliphatic alcohol esters described in JP-A No. 51-47334 or 57-196231, those having an aromatic skeleton described in JP-A No. 59-5240, 59-5241, or 2-226149, and those containing an amino group described in JP-A No. 1-165613. Further, a mixture of two or more of the ester monomers may be used.

Specific examples of the monomers of an amide of an aliphatic polyhydric amine compound with an unsaturated carboxylic acid include methylene bis-acrylamide, methylene bis-methacrylamide, 1,6-hexamethyelne bis-acrylamide, 1,6-hexamethyelne bis-methacrylamide, diethylenetriamine trisacrylamide, xylylene bisacrylamide, and xylylene bismethacrylamide. Other preferable examples of amide monomers include those having a cyclohexylene structure described in JP-B No. 54-21726.

Further, a urethane addition-polymerizable compound produced by an addition reaction between an isocyanate and a hydroxyl group may be suitably used. Specific examples thereof include vinyl urethane compounds having two or more polymerizable vinyl groups per molecule thereof, which are obtained by adding a vinyl monomer containing a hydroxyl group as represented by the following Formula (A) to a polyisocyanate compound having two or more isocyanate groups per molecule thereof, as described in, for example, JP-B No. 48-41708.

$$CH_2{=}C(R^4)COOCH_2CH(R^5)OH \qquad (A)$$

In Formula (A), $R^4$ and $R^5$ independently represent H or $CH_3$.

As for these polymerizable compounds, details of the method of use such as their structures, the single or combination use, or the addition amount may be arbitrarily determined depending on the final performance design of the photosensitive resin composition. For example, from the viewpoint of sensitivity, a structure having a large content of unsaturated groups per molecule is preferably used. In many cases, a difunctional or more functional compound is preferably used. From the viewpoint of increasing the strength of a cured film, a trifunctional or more functional compound is preferably used.

Use of a combination of compounds having different functional number and/or different species of polymerizable groups (e.g., an acrylic acid ester, a methacrylic acid ester, a styrene compound, and a vinyl ether compound) is also effective for controlling both the sensitivity and the strength. The selection and usage method of the polymerizable compound are important factors also for the compatibility with other components (e.g., a photopolymerization initiator, a coloring agent (a pigment or a dye), and a binder polymer) and the dispersibility thereof. For example, the compatibility may be improved by using a compound having a low purity or a combination of two or more compounds. From the viewpoint of improving the adhesion to a hard surface such as a support, a specific structure may also be selected.

The content of the polymerizable compound in the total solid content of the photosensitive resin composition (which means the total content in the case in which two or more species of polymerizable compounds are used) is not

particularly limited, and it is preferably from 10 to 80% by mass, more preferably from 15 to 75% by mass, and particularly preferably from 20 to 60% by mass, from the viewpoint of more effectively obtaining the effects of the invention.

*Photopolymerization initiator*

The photosensitive resin composition of the invention contains at least one photopolymerization initiator. The photopolymerization initiator is not particularly limited as long as it can polymerize the photopolymerizable compound. It is preferably selected from the viewpoint of characteristics, initiation efficiency, absorption wavelength, availability, and cost.

Examples of photopolymerization initiators include at least one active halogen compound selected from halomethyloxadiazole compounds and halomethyl-s-triazine compounds, 3-aryl-substituted coumarin compounds, lophine dimers, benzophenone compounds, acetophenone compounds and derivatives thereof, cyclopentadiene-benzene-iron complexes and salts thereof, and oxime compounds. Among them, the oxime compounds are preferable from the viewpoint of suppressing the releasing of a light-shielding color filter (i.e., release of a light-shielding color filter formed, particularly, on a substrate having a structure).

The oxime compound (which may be hereinafter referred to as "oxime photopolymerization initiator") is not particularly limited. Examples of oxime compounds include oxime compounds described in JP-A No. 2000-80068, WO02/100903 Al, or JP-A No. 2001-233842.
Specific examples of oxime compounds include, but not limited to,
2-(O-benzoyloxime)-1-[4-(phenylthio)phenyl]-1,2-butanedione, 2-(O-benzoyloxime)-1-[4-(phenylthio)phenyl]-1,2-pentanedione, 2-(O-benzoyloxime)-1-[4-(phenylthio)phenyl]-1,2-hexanedione, 2-(O-benzoyloxime)-1-[4-(phenylthio)phenyl]-1,2-heptanedione, 2-(O-benzoyloxime)-1-[4-(phenylthio)phenyl]-1,2-octanedione, 2-(O-benzoyloxime)-1-[4-(methylphenylthio)phenyl]-1,2-butanedione, 2-(O-benzoyloxime)-1-[4-(ethylphenylthio)phenyl]-1,2-butanedione, 2-(O-benzoyloxime)-1-[4-(butylphenylthio)phenyl]-1,2-butanedione, 1-(O-acetyloxime)-1-[9-ethyl-6-(2-methylbenzoyl)-9H-carbazol-3-yl]ethanone, 1-(O-acetyloxime)-1-[9-methyl-6-(2-methylbenzoyl)-9H-carbazol-3-yl]ethanone, 1-(O-acetyloxime)-1-[9-propyl-6-(2-methylbenzoyl)-9H-carbazol-3-yl]ethanone, 1-(O-acetyloxime)-1-[9-ethyl-6-(2-ethylbenzoyl)-9H-carbazol-3-yl]ethanone, and 1-(O-acetyloxime)-1-[9-ethyl-6-(2-butylbenzoyl)-9H-carbazol-3-yl]ethanone.

Among them, preferable examples include
2-(O-benzoyloxime)-1-[4-(phenylthio)phenyl]-1,2-octanedione and
1-(O-acetyloxime)-1-[9-ethyl-6-(2-methylbenzoyl)-9H-carbazol-3-yl]ethanone, Specific examples thereof include CGI-124 and CGI-242 (both trade names, manufactured by Ciba Specialty Chemicals).

The photopolymerization initiator may be used in combination with a sensitizer, a light stabilizer, or the like.
Further, known initiators other than the photopolymerization initiators may be used for the photosensitive resin composition of the invention.

Only one of the photopolymerization initiators may be used singly, or a combination of two or more thereof may be used.
The content of the photopolymerization initiator in the total solid content of the photosensitive resin composition (which means the total content in the case in which two or more species of photopolymerization initiators are used) is preferably from 3 to 20% by mass, more preferably from 4 to 19% by mass, and particularly preferably from 5 to 18% by mass, from the viewpoint of more effectively obtaining the effects of the invention.

*Surfactant*

The photosensitive resin composition according to the invention may contain a surfactant in order to improve the coatability. Examples of the surfactant include various surfactants such as a fluorine-containing surfactant, a nonionic surfactant, a cationic surfactant, an anionic surfactant, and a silicone surfactant.

In particular, when the photosensitive resin composition according to the invention contains a fluorine-containing surfactant, the liquid properties (in particular, fluidity) of the composition prepared as a coating liquid are improved, and the uniformity of the coating thickness and the liquid saving property can be improved.
That is, when a photosensitive resin composition including a fluorine-containing surfactant is used as a coating liquid to form a film, the wettability on the surface to be coated is improved due to decrease in the surface tension between the surface to be coated and the coating liquid, and the coatability on the surface to be coated is improved. Therefore, even when a thin film of several micrometers thickness is formed with a small amount of the liquid, a film with uniform thickness may be suitably formed.

The fluorine content in the fluorine-containing surfactant is preferably from 3% by mass to 40% by mass, more preferably from 5% by mass to 30% by mass, and still more preferably from 7% by mass to 25% by mass. When the fluorine content of the fluorine-containing surfactant is within the above range, it is effective in terms of the uniformity of the coating film thickness and the liquid saving, and excellent solubility in the photosensitive resin composition can be

achieved.

Examples of the fluorine-containing surfactant include MEGAFAC F171, F172, FI73, F176, F177, F14L, F142, F143, F144, R30, F437, F475, F479, F482, F554, F780 and F781 (all trade names, manufactured by DIC Corporation), FLUORAD FC430, FC431 and FC171 (all trade names, manufactured by Sumitomo 3M Limited), SURFLON S-382, SC-101, SC-103, SC-104, SC-105, SC-1068, SC-381, SC-383, S-393 and KH-40 (all trade names, manufactured by Asahi Glass Co., Ltd.), and SOLSPERSE 20000 (trade name, manufactured by Lubrizol Japan Limited).

Examples of the nonionic surfactant include glycerol, trimethylolpropane and trimethylolethane, and an ethoxylate or propoxylate product thereof (such as glycerol propoxylate or glycerin ethoxylate); polyoxyethylene lauryl ether, polyoxyethylene stearyl ether, polyoxyethylene oleyl ether, polyoxyethylene octyl phenyl ether, polyoxyethylene nonyl phenyl ether, polyethylene glycol dilaurate, polyethylene glycol distearate, and sorbitan fatty acid esters such as PLURONIC L10, L31, L61, L62, 10R5, 17R2 and 25R2, and TETRONIC 304, 701, 704, 901, 904 and 150R1 (all trade names, manufactured by BASF).

Examples of the cationic surfactant include phthalocyanine derivatives s such as EFKA-745 (trade name, manufactured by Morishita & Co., Ltd.), organosiloxane polymers such as KP341 (trade name, manufactured by Shin-Etsu Chemical Co., Ltd.); (meth)acrylic acid (co)polymers such as POLYFLOW No.75, No.90, No.95 (all trade names, manufactured by Kyoeisha Chemical Co., Ltd.); and W001 (trade name, available from Yusho Co., Ltd.).

Examples of the anionic surfactant include W004, W005 and W017 (all trade names, available from Yusho Co., Ltd.).

Examples of the silicone surfactant include TORAY SILICONE DC3PA, SH7PA, DC11PA, SH21PA, SH28PA, SH29PA, SH30PA and SH8400 (all trade names, manufactured by Dow Corning Toray Co., Ltd.), TSF-4440, TSF-4300, TSF-4445, TSF-4460 and TSF-4452 (all trade names, manufactured by Momentive Performance Materials Inc.), KP341, KF6001, and KF6002 (all trade names, manufactured by Shin-Etsu Chemical Co., Ltd.), and BYK307, BYK323 and BYK330 (trade names, manufactured by BYK Chemie).

Any one of these surfactants may be used shingly, or a combination of two or more thereof may be used.

When the photosensitive resin composition contains a surfactant, the amount of the surfactant to be added is preferably from 0.001% by mass to 2.0% by mass, more preferably from 0.005% by mass to 1.0% by mass, with respect to the total mass of the photosensitive resin composition.

*Other components*

The photosensitive resin composition of the invention may contain a solvent component. The solvent component is as described in the section "Dispersion composition and method for producing the same", and preferable ranges thereof are also the same as those described therein.

The photosensitive resin composition may contain at least one component selected from known additive agents such as a sensitizer, a co-sensitizer, a thermal polymerization inhibitor, adhesion improvers (e.g., a silane coupling agent and a titanium coupling agent) for improving the adhesion to a hard surface such as a support, an inorganic filler and a plasticizer for improving physical properties of a cured film, and an oil-sensitizing agent. If necessary, the photosensitive resin composition may contain a chain transfer agent, an azo compound that increases the cure degree of a film owing to post-heating performed after light exposure and development, a thermal polymerization initiator such as a peroxide compound, a thermal polymerization component, an ultraviolet absorber such as alkoxy benzophenone, a plasticizer such as dioctyl phthalate, a development improver such as a low-molecular-weight organic carboxylic acid, as well as various additives such as a filler, a polymeric compound other than the alkali-soluble resin, an antioxidant or aggregation inhibitor, or a polyfunctional thiol or an epoxy compound that for the purpose of increasing film strength and sensitivity.

As for the sensitizer, a sensitizer which sensitizes the photopolymerization initiator by an electronic transition mechanism or an energy transfer mechanism is preferably used. Examples of sensitizers include those belonging to the compounds as listed below and having an absorption wavelength in a wavelength region of from 300 nm to 450 nm. Examples thereof include polynuclear aromatic compounds (e.g., phenanthrene, anthracene, pyrene, perylene, triphenylene, 9,10-dialkoxyanthracene), xanthenes, thioxanthones, cyanines, merocyanines, phthalocyanines, thiazines, acridines, anthraquinones, squaryliums, acridine orange, coumarins, ketocoumarin, phenothiazins, phenazines, styryl benzenes, azo compounds, diphenylmethane, triphenylmethane, distyrylbenzenes, carbazoles, porphyrin, spiro compounds, quinacridone, indigo, styryl, pyrylium compounds, pyrromethene compounds, pyrazolotriazole compounds, benzothiazole compounds, barbituric acid derivatives, thiobarbituric acid derivatives, aromatic ketone compounds such as acetophenone, benzophenone, thioxanthone, or Michler's ketone, and heterocycle compounds such as N-aryl oxazolidinone.

Further, the co-sensitizer has a function of further improving the sensitivity of the photopolymerization initiator or sensitizer toward actinic radiation or suppressing polymerization inhibition of a photopolymerizable compound caused by oxygen. Examples of co-sensitizers include amines (such as triethanolamine, p-dimethylaminobenzoic acid ethyl ester, p-formyidimethylaniline, and p-methylthiodimethylaniline), thiols and sulfides (such as 2-mercaptobenzothiazole, 2-mercaptobenzooxazole, 2-mercaptobenzimidazole, 2-mercapto-4(3H)-quinazoline, and β-mercaptonaphthalene), amino acid

compounds (e.g., N-phenylglycine), organometallic compounds (e.g., tributyltin acetate), hydrogen donors, and sulfur compounds (e.g. trithiane).

Unnecessary thermal polymerization of the photopolymerizable compound during the production or storage of the composition may be prevented by adding the thermal polymerization inhibitor. Examples of thermal polymerization inhibitors include hydroquinone, p-methoxyphenol, di-t-butyl-p-cresol, pyrogallol, t-butyl-catechol, benzoquinone, 4,4'-thiobis(3-methyl-6-t-butylphenol),
2,2'-methylenebis(4-methyl-6-t-butylphenol), and N-nitrosophenylhydroxyamine cerium (I) salt. If necessary, higher fatty acid derivatives such as behenic acid and behenic acid amide may be added to prevent the polymerization inhibition caused by oxygen. The derivatives may be unevenly distributed on the surface of the coating film in the process of drying after the coating.

*Light-shielding color filter*

The light-shielding color filter of the invention is one formed using the photosensitive resin composition of the invention.
Since the light-shielding color filter of the invention is formed using the photosensitive resin composition of the invention in which the occurrence of coated surface abnormalities (i.e., leakage in light shielding) is inhibited when the dispersion composition is made into a coating film, the leakage in light shielding in the light-shielding color filter is suppressed; therefore, the light-shielding color filter has an excellent light-shielding capability.

The light-shielding color filter refers to a light-shielding pattern obtained by exposing and developing a photosensitive resin composition containing at least a black coloring material, a photopolymerizable compound, a resin, a photopolymerization initiator, and a solvent. The color of the light-shielding color filter may be an achromatic color such as black or gray, or may be black, gray, or the like with which a tint of chromatic color has been mixed. Since the light-shielding color filter is obtained by exposing and developing a photosensitive resin composition containing at least a black coloring material, a photopolymerizable compound, a resin, a photopolymerization initiator and a solvent, it may also be referred to as a light-shielding film or a light-shielding filter.
The light-shielding color filter can be preferably used for various applications such as, in a solid-state image sensor, for blocking light in portions other than a light receiving portion in a surface at which a light receiving element is formed, for blocking light on a surface opposite to the surface at which a light receiving element is formed, or for use as a pixel for adjusting color (for example, pixels of achromatic color such as black or gray, or pixels of black, gray, or the like with which chromatic colors have been mixed).

The film thickness of the light-shielding color filter is not particularly limited, and is preferably from 0.1 μm to 10 μm, more preferably from 0.3 μm to 5.0 μm, and still more preferably from 0.5 μm to 3.0 μm, in order to obtain the effects of the invention more efficiently. The pattern size of the light-shielding color filter is not particularly limited and is preferably from 1,000 μm or smaller, more preferably from 500 μm or smaller, and still more preferably from 300 μm or smaller, in order to obtain the effects of the invention more efficiently. The lower limit of the pattern size is preferably I μm.

Spectral characteristics of the light-shielding color filter of the invention are not particularly limited. From the viewpoint of improving light-shielding capability of an infrared region which may be required for the solid-state image sensor, the viewpoint of the balance in light-shielding capabilities between a visible region and an infrared region, and the viewpoint of obtaining the effects of the invention more effectively, the ratio [$OD_{1200}$/$OD_{365}$] of the optical density ($OD_{1200}$) at a wavelength of 1,200 nm and the optical density ($OD_{365}$) at a wavelength of 365 nm is preferably from 0.5 to 3.
The optical density (OD) is a value obtained by measuring the transmittance of the obtained film using a measuring apparatus (trade name: UV-3600, manufactured by Shimadzu Corporation) and converting the obtained transmittance (%T) by the following Equation B.

$$\text{Equation B:} \qquad \text{OD value} = -\text{Log}\ (\%T/100)$$

In the invention, the optical density at a wavelength λ nm is indicated by "ODλ".
From the viewpoint of the balance of light-shielding capabilities between a visible region and an infrared region and the viewpoint of obtaining the effects of the invention more effectively, suitable conditions of the optical density of the light-shielding color filter are as follows. That is, the ratio [$OD_{1200}$/$OD_{365}$] is more preferably from 1.0 to 2.5, and particularly preferably from 1.3 to 2.0.
The optical density ($OD_{1200}$) at a wavelength of 1200 nm of the light-shielding color filter is preferably from 1.5 to 10, and more preferably from 2 to 10.
The optical density ($OD_{365}$) at a wavelength of 365 nm of the light-shielding color filter is preferably from 1 to 7, and more preferably from 2 to 6.

The optical density in the wavelength region of from 900 nm to 1300 nm of the light-shieiding color filter is preferably from 2 to 10, more preferably from 2 to 9, and particularly preferably from 2 to 8.
The ratio [$OD_{900}$/$OD_{365}$] of the light-shielding color filter is preferably from 1.0 to 2.5, and more preferably from 1.1 to 2.5.
The ratio [$OD_{1100}$/$OD_{365}$] of the light-shielding color filter is preferably from 0.6 to 2.5, and more preferably from 0.7 to 2.5.
The ratio [$OD_{1300}$/$OD_{365}$] of the light-shielding color filter is preferably from 0.4 to 2.3, and more preferably from 0.5 to 2.0.
The light-shielding color filter of the invention may be suitably used for solid-state image sensors such as a charge-coupled devices (CCD) or a complementary metal-oxide semiconductor (CMOS). Specifically, the light-shielding color filter of the invention is suitably used for a solid-state image sensor such as a CCD or CMOS having more than 1 million pixels.
Specifically, the filter is suitably used when it is a thin film having a thickness of 2 μm or less, and preferably 1 μm or less. In this case, the content of components which contribute to photolithography properties except the coloring agent in the film is relatively decreased. Moreover, the contents of other components are further decreased by the increased content of the black color material, and the transmission amount of light to the film is lowered. Therefore, the lower film portion which undergoes low-light exposure tends to be excessively developed, whereby an inverse tapered shape may be readily formed, and the pattern is easily separated. This becomes significant when the thickness of a film to be formed is from 0.005 μm to 0.9 μm, and more specifically from 0.1 μm to 0.7 μm.

*Method of producing light-shielding color filter*

The method of producing a light-shielding color filter of the invention includes:

applying the photosensitive resin composition for a light-shielding color filter of the invention to a support to form a photosensitive layer (which may be hereinafter referred to as "photosensitive layer forming step");
subjecting the photosensitive layer into pattern exposure (which may be hereinafter referred to as "exposing step"); and
developing the photosensitive layer after the exposure to form a colored pattern (which may be hereinafter referred to as "developing step").

Hereinafter, each step in the method of producing a light-shielding color filter of the invention will be described.

*Photosensitive layer forming step*

In the photosensitive layer forming step, a photosensitive layer is formed by applying the photosensitive resin composition of the invention is applied to a support.
Examples of supports include a photoelectric conversion element substrate which is used for a solid-state image sensor, such as a silicon substrate (or a silicon wafer) and a complementary metal oxide semiconductor (CMOS). Further, an undercoat layer may be provided on the support, if necessary, for the purpose of improving the adhesion with an upper layer, preventing substance diffusion, or for planarization of the substrate surface. In the light-shielding color filter of the invention and the method of producing the same, when a substrate (namely, a substrate having a patterned structure formed thereon) is used as a support, the effect of suppressing the releasing of the pattern of the invention is exerted more effectively. The patterned structure may be any one of various patterned structures such as a thin-film transistor, a photoelectric conversion element, or a passivation film and a color pattern (e.g., red, green, blue, or transparent pattern) which has been provided on the substrate before the light-shielding color filter is formed.
Any one of various coating methods such as slit coating, ink-jetting, spin coating, flow casting coating, roll coating, or screen printing may be used as a method of coating the support with the photosensitive resin composition of the invention.
The thickness (i.e., dry film thickness) of a coating film formed using the photosensitive resin composition is preferably from 0.35 μm to 3.0 μm, and more preferably from 0.50 μm to 2.5 μm from the viewpoint of resolution and development properties.
The photosensitive resin composition which has been applied to the support is usually dried at 70 to 1.30°C for about 2 minutes to 4 minutes, thereby forming a photosensitive layer.

*Exposing step*

In the exposing step, the photosensitive layer formed by the photosensitive layer forming step is subjected to pattern exposure using, for example, a mask and cured. When the photosensitive layer is exposed to light through a mask, only a photo-irradiated coating film portion is cured.
It is preferable to perform exposure by irradiation with a radiation. Specifically, ultraviolet rays such as g-rays,

h-rays, or i-rays are preferably used as the radiation which may be used at the time of exposing. A high-pressure mercury-vapor lamp is more preferably used. The irradiation intensity is preferably from 5 to 3,000 mJ, more preferably from 10 to 2,000 mJ, and most preferably from 10 to 1,000 mJ.

*Developing step*

After the exposing step, the photosensitive layer after the exposure is developed, for example, by an alkaline development treatment to form a colored pattern. In the developing step, dissolving a non-irradiated portion of the photosensitive layer obtained in the exposing step is dissolved using an alkaline aqueous solution, whereby only a photo-irradiated portion of the photosensitive layer is left.

From the viewpoint that a basic circuit or the like is not damaged, an organic alkali developer is desirably used as a developer. Usually, the developing temperature is from 20 to 30°C and the developing time is from 20 seconds to 240 seconds.

Examples of developers include an alkaline aqueous solution prepared by diluting an organic alkali compound with pure water so as to have a concentration of 0.001 to 10% by mass, and preferably 0.01 to 1% by mass. Usable examples of organic alkali compounds include aqueous ammonia, ethylamine, diethylamine, dimethylethanolamine, tetramethylammonium hydroxide, tetraethylammonium hydroxide, choline, pyrrole, piperidine, and 1,8-diazablcyclo-[5,4,0]-7-undecene. In this regard, when an alkaline aqueous solution is used as a developer, rinsing with pure water is generally performed after the development.

If necessary, the method of producing a light-shielding color filter of the invention may further include curing the pattern after the development by heating and/or exposing (which may be referred to as " a curing step"), in addition to the photosensitive layer forming step, the exposing step, and the developing step.

*Solid-state image sensor*

The solid-state image sensor of the invention has at least the light-shielding color filter of the invention. Since the solid-state image sensor of the invention has the light-shielding color filter of the invention in which the leakage in light shielding is suppressed, the noise which may be generated in the solid-state image sensor is reduced, and the solid-state image sensor has excellent color reproducibility.

The structure of the solid-state image sensor is not particularly limited as long as it has the light-shielding color filter of the invention and has a structure that functions as a solid-state image sensor. Examples thereof include a structure which has: a support; and, on the support, multiple photodiodes that form a light-receiving area of a solid-state image sensor (e.g., CCD or CMOS image sensor) and a light-sensitive element made of polysilicon; and the light-shielding color filter of the invention at the light-sensitive element surface side of the support (e.g., at portions other than the light-receiving unit or at the color-adjusting pixel unit) or at the opposite side of the light-sensitive element surface side.

EXAMPLES

Hereinafter, the invention will be described in more detail with reference to Examples. However, the invention is not limited to these Examples as long as it does not depart from the gist of the invention. Unless otherwise indicated, "part(s)" means "part(s) by mass". Further, the room temperature means 25°C.

*Synthesis of dispersants*

*Synthesis of dispersant 1*

First, 600.0 g of ε-caprolactone and 22.8 g of 2-ethyl-1-hexanol were introduced into a 500-mL three-necked flask, and were stirred and dissolved while nitrogen was blown thereinto. Then, 0.1 g of monobutyltin oxide was added thereto, and the mixture was heated to 100°C. Eight hours later, the disappearance of the raw materials was confirmed by gas chromatography, and the mixture was cooled to 80°C. Then, 0.1 g of 2,6-di-t-butyl-4-methylphenol was added, and 27.2 g of 2-methacryloyloxyethyl isocyanate were added. Five hours later, the disappearance of the raw materials was confirmed by $^1$H-NMR, and the resulting mixture was cooled to room temperature, thereby obtaining 200 g of a precursor M1 (the following structure) in a solid state. The fact that the resulting product was the precursor M1 was confirmed by $^1$H-NMR, IR, and mass analysis.

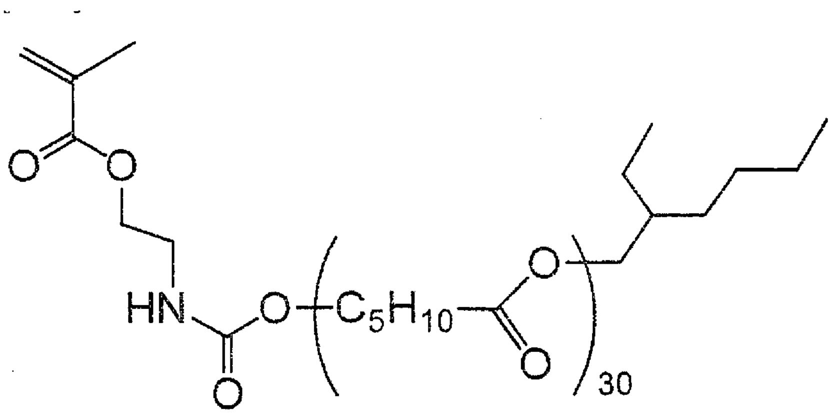

M1

Next, 30.0 g of the precursor M1, 70.0 g of NK ester CB-1, 2.3 g of dodecyl mercaptan, and 233.3 g of propylene glycol monomethyl ether acetate were put into a nitrogen-substituted three-necked flask, and were stirred using a stirrer (trade name: THREE-ONE MOTOR, manufactured by Shinto Scientific Co., Ltd.) and heated up to 75°C while nitrogen was blown into the flask. Then, 0.2 g of dimethyl 2,2-azobis(2-methylpropionate) (trade name: V-601, manufactured by Wako Pure Chemical Industries, Ltd.) was added thereto, and the resulting mixture was heated and stirred at 75°C for 2 hours. Two hours later, 0.2 g of V-601 was additionally added thereto, and the mixture was heated and stirred for 3 hours, thereby obtaining a 30% solution of the following dispersant 1.
The composition ratio, acid value, and weight average molecular weight (Mw) of the dispersant 1 are shown in Table 1 below. The weight average molecular weight is a value obtained by measuring by gel permeation chromatography (GPC) and calculating in polystyrene equivalent. In GPC, an analyzer (trade name: HLC-8020GPC, manufactured by TOSOH CORPORATION) was used and columns (trade names: TSKGEL SUPERHZM-H, TSK GEL SUPER HZ4000, and TSK GEL SUPER HZ200, manufactured by TOSOH CORPORATION) were used.

*Synthesis of dispersants 2 to 5*

The following dispersants 2 to 5 were synthesized by the same synthetic method as the synthetic method of the dispersant 1. The composition ratio, acid value, and weight average molecular weight (Mw) of these dispersants are shown in Table 1 below.

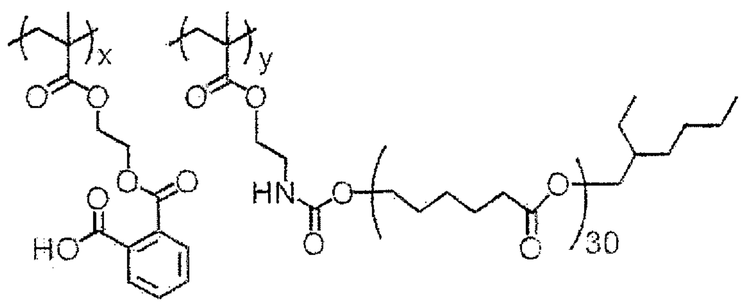

Dispersant 1

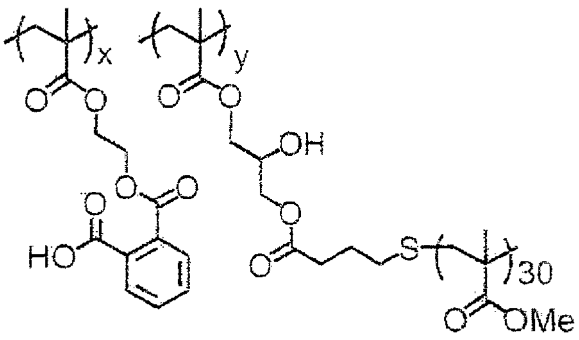

Dispersant 2

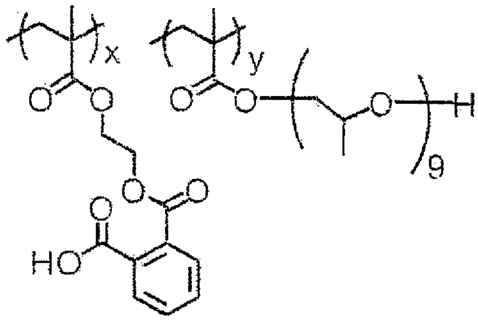

Dispersant 3

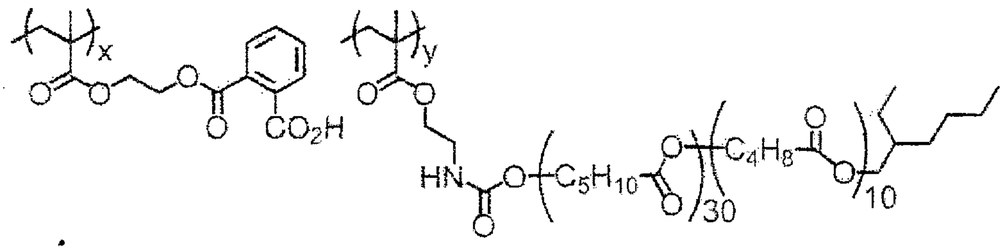

Dispersant 4

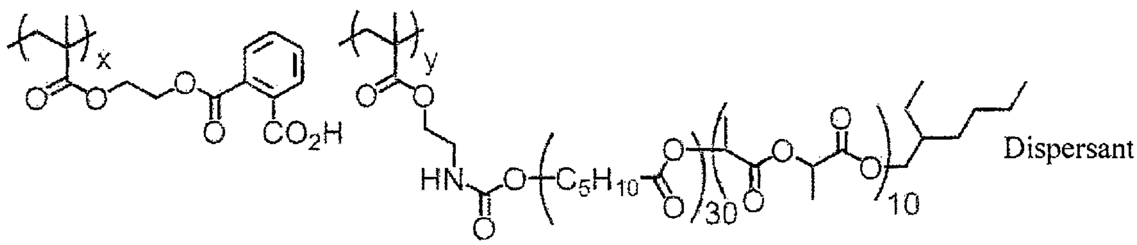

Dispersant 5

*Example 1*

*Preparation of titanium black dispersion liquid*

A mixed liquid obtained by mixing the following composition was subjected to a dispersion treatment using a high-shear circulation type disperser (the first dispersion process; the dispersion apparatus and the dispersion conditions are shown below). Thereafter, a dispersion treatment using a bead mill (the second dispersion process; the dispersion apparatus and the dispersion conditions are shown below) was started.

*Composition of mixed liquid*

| | |
|---|---|
| ·Titanium black (trade name: 13M-T, manufactured by Mitsubishi Materials Corporation) | 29.4 parts by mass |
| ·Dispersant 1 | 26.5 parts by mass |
| ·Solvents 1 and 2 (solvent species and mass ratio [solvent 1/solvent 2] are shown in Table 1) | 44.1 parts by mass (the total of solvents 1 and 2) |

*First dispersion process*

· Dispersion apparatus: High-shear circulation type disperser (trade name: Magic LAB, manufactured by IKA)
· Dispersion conditions:

| | |
|---|---|
| Treatment time | 30 min |
| Water-cooled temperature | 25 to 29°C |
| Shear rate | 230,000 (1/s) |

(The shear rate was calculated at a rotational frequency of 14,650 (1/s) with a gap of 0.01 mm.)

*Second dispersion process*

· Dispersion apparatus: bead mill (trade name: ULTRA APEX MILL UAM015, manufactured by KOTOBUKI INDUSTRIES CO.,LTD)
· Treatment conditions:

| | |
|---|---|
| Diameter of beads | φ0.05 mm |
| Filling rate of beads | 75% by volume |
| Mill peripheral speed | 12 m/sec |
| Amount of mixed liquid to be treated | 680 g |
| Circulating flow amount (pump supply amount) | 30 kg/hour |
| Temperature of liquid to be treated | 25 to 30°C |
| Cooling water | tap water |
| Volume of circular path of bead mill | 0.15 L |

After the start of dispersion in the second dispersion process, the volume average particle diameter was measured at 30-minute intervals (time period for one pass) while the dispersion treatment was performed under the above-mentioned conditions. At this time, the volume average particle diameter decreased as the dispersion time increased (i.e., as the number of passes increased). However, the amount of change thereof gradually decreased. At the time at which the change in the volume average particle diameter per pass reached 10 nm or less each time the dispersion time period was extended by 30 minutes (namely, at the time at which the change in the volume average particle diameter reached 10 nm/pass or less; the process up to this time corresponding to the "first stage of dispersion treatment"), 120 g of propylene glycol monomethyl ether acetate solution of the dispersant 1. which has the composition shown below, was added to the dispersion liquid.
Composition

| | |
|---|---|
| ·Dispersant 1 | 30 parts by mass |
| ·Propylene glycol monomethyl ether acetate | 70 parts by mass |

After the addition of the solution (dispersant), 10 passes of dispersion treatment was further continued. When the change in the volume average particle diameter per pass (30 minutes) reached 10 nm or less, the preparation of the titanium black dispersion liquid was completed.
The titanium black dispersion liquid was prepared in the manner described above.

*Measurement of number of coarse particles*

The number of coarse particles included in the obtained titanium black dispersion liquid (i.e., the number of particles having a volume average particle diameter of 0.1 μm or more contained per 1 μL of the titanium black dispersion liquid) was measured.
The measurement was performed using a measuring apparatus (trade name: FPIA3000, manufactured by SYSMEX CORPORATION), and a sample obtained by 100-fold diluting the dispersion liquid.
The results of measurement are shown in Table 1.

*Precipitation test*

The obtained titanium black dispersion liquid was subjected to precipitation test.
Specifically, a solid concentration (a) of the dispersion liquid before the passage of predetermined time (six months) and a solid concentration (b) of the dispersion liquid after the passage of time (six months) were respectively measured. The rate of change of solid concentration (%) was determined by the following Equation (1), and the precipitation property of titanium black was evaluated in accordance with the following evaluation criteria. The precipitation test was carried out under the conditions of room temperature and -5°C (refrigeration), respectively.
The evaluation results are shown in Table 1 below.
$$\text{Equation (1):} \quad \text{Rate of change of solid concentration (\%)} = [1 - (b/a)] \times 100$$

*Evaluation criteria of precipitation property*

A: The rate of change of solid concentration was less than 3%.
B: The rate of change of solid concentration was 3% or more and less than 10%.
C: The rate of change of solid concentration was 10% or more.

Here, the solid concentration was obtained in such a manner that 5 g of the dispersion liquid was weighed and heated in an oven at 165°C for 60 minutes, and then the amount of the dispersion liquid remaining after the heating was measured, followed by calculation according to the following Equation (2).
$$\text{Equation (2):} \quad \text{Solid concentration [\% by mass]} = \text{Amount of dispersion liquid after heating/Amount of dispersion liquid before heating} \times 100$$

The solid concentration after the passage of time was measured in the following manner: the titanium black dispersion liquid was put in 50-mL containers made of resin, and the containers were allowed to stand at either room temperature or at -5°C (refrigeration), respectively, for six months; 5 g of the supernatant liquid to a depth of 1 cm from the top of the liquid surface was collected; and the solid concentration of the obtained dispersion liquid was measured.

*Preparation of photosensitive resin composition*

The following components were mixed, thereby obtaining a photosensitive resin composition.
Composition of photosensitive resin composition

| | |
|---|---|
| · Titanium black dispersion liquid prepared above | 50 parts by mass |
| · Dipentaerythritol hexaacrylate (T-1 shown below) | 8 parts by mass |
| · Oxime photopolymerization initiator (K-1 shown below) | 5 parts by mass |
| · Resin (J-1 shown below; the weight average molecular weight (Mw) is shown below) | 10 parts by mass |
| · Propylene glycol monoethyl ether acetate | 27 parts by mass |

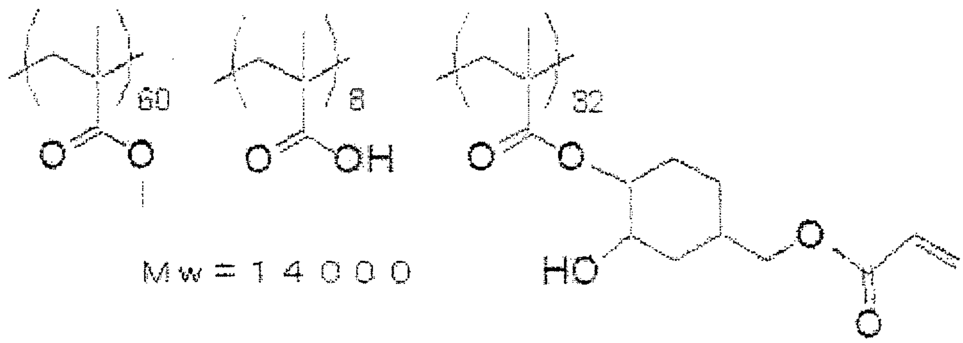

Mw = 14000

J-1

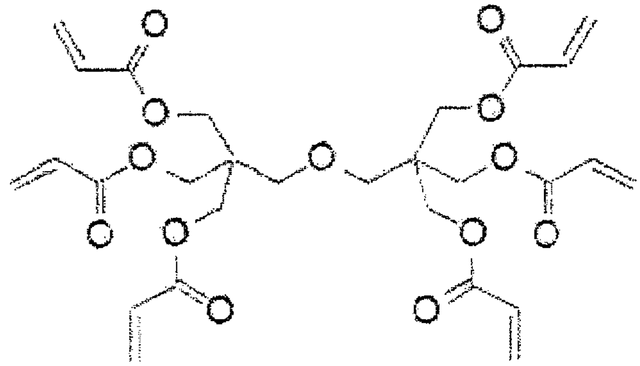

T-1

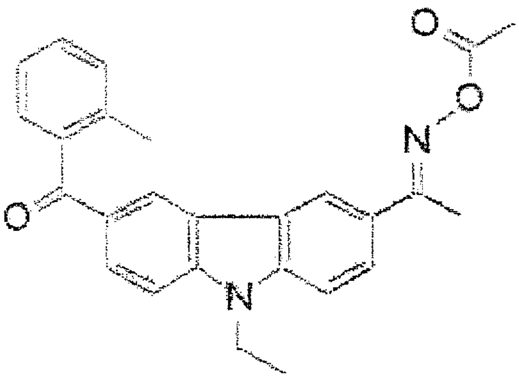

K-1

*Temporal stability*

The photosensitive resin composition was applied to a glass substrate by spin coating, and heated on a hot plate at 120°C for 2 minutes, thereby obtaining a photosensitive layer.
Subsequently, the photosensitive layer was exposed at an exposure amount of 200 mJ/cm$^2$ using an i-line stepper, thereby obtaining a light-shielding film.
Regarding the obtained light-shielding film, the absorbance at a wavelength of 550 nm was measured using a spectroscope (trade name: UV3600, manufactured by Shimadzu Corporation), and the resulting value was defined as an absorbance (i).

Separately, the photosensitive resin composition was enclosed in a 100-mL glass container, and was allowed to stand at room temperature for six months. Then, the photosensitive resin composition was sampled at a depth of 2 cm from the liquid surface.
A light-shielding film was produced in the same manner as described above using the sampled photosensitive resin composition. The absorbance thereof was measured, and the resulting value was defined as an absorbance (ii).
The rate of change of absorbance before and after the six-month standing was calculated from the measured absorbances

(i) and (ii). The temporal stability (i.e., storage stability) was evaluated in accordance with the following evaluation criteria. Evaluation results are shown in Table 1.

Evaluation criteria

A: The rate of change of absorbance was less than 3%.
B: The rate of change of absorbance was 3% or more and less than 10%.
C: The rate of change of absorbance was 10% or more.

*Coated surface abnormalities*

The glass substrate having the coating film formed thereon was irradiated with light from the rear surface thereof (i.e., the surface of the glass substrate at which the light-shielding film was not formed), and the surface state of the light-shielding film (i.e., the front surface of the glass substrate at which the light-shielding film was formed) was observed using an optical microscope (magnification: 100 times).
The leakage in light shielding considered to be a trace of bubbles was counted as the coated surface abnormality.
The results are shown in Table 1.
The number of leakage in light shielding present per an area of 0.01 $m^2$ is shown in Table 1.

*Examples 2 to 17 and Comparative examples 1 to 5*

Titanium black dispersion liquids and photosensitive resin compositions of Examples 2 to 17 and Comparative Examples 1 to 5 were prepared in the same manner in Example 1 except that the dispersant 1 used for "Preparation of titanium black dispersion liquid" in Example I was respectively changed to the dispersants shown in Table 1 below, and the species of the solvent 2, the mass ratio [solvent 1/solvent 2], and the shear rate were changed, respectively. Then, the same evaluation as that of Example I was performed.
The results are shown in Table 1 below.

Table 1

| | Dispersant | Composition ratio | | Acid value (mgKOH/g) | Mw | Solvent) 1 | Solvent 2 | Mass ratio [solvent 1/solvent 2] | First dispersion process | Shear rate (1/s) | Evaluation | | | | |
|---|---|---|---|---|---|---|---|---|---|---|---|---|---|---|---|
| | | X (%by mass) | Y (% by mass) | | | | | | | | The number of coarse particles (particles/ µL) | Precipitation property | | Temporal stability of the composition | Coated surface abnormality (the number) |
| | | | | | | | | | | | | Room temperature | -5°C | | |
| Example 1 | Dispersant 1 | 35 | 65 | 80 | 30000 | PGMEA | Butyl acetate | 70/30 | Included | 230000 | 181 | A | A | A | 0 |
| Example 2 | Dispersant 1 | 70 | 30 | 120 | 31000 | PGMEA | Butyl acetate | 70/30 | Included | 230000 | 192 | A | A | A | 1 |
| Example 3 | Dispersant 1 | 70 30 | | 120 | 31000 | PGMEA | EFP | 70/30 | Included | 230000 | 156 | A | A | A | 0 |
| Example 4 | Dispersant 1 | 70 | 30 | 120 | 31000 | PGMEA | Cyclohexanone | 70/30 | Included | 230000 | 170 | A | A | A | 4 |
| Example 5 | Dispersant 1 | 70 | 30 | 120 | 31000 | PGMEA | PGME | 70/30 | Included | 230000 | 125 | A | A | A | 2 |
| Example 6 | Dispersant 1 | 70 | 30 | 120 | 31000 | PGMEA\ | 2-heptanone | 70/30 | Included | 230000 | 125 | A | A | A | 2 |
| Example 7 | Dispersant 2 | 70 | 30 | 115 | 31000 | PGMEA | Butyl acetate | 70/30 | Included | 230000 | 132 | A | A | A | 3 |
| Example 8 | Dispersant 3 | 70 | 30 | 126 | 32900 | PGMEA | Butyl acetate | 70/30 | Included | 230000 | 178 | A | A | A | 1 |
| Example 9 | Dispersant 4 | 70 | 30 | 100 | 29100 | PGMEA | Butyl acetate | 70/30 | Included | 230000 | 168 | A | A | A | 1 |
| Example 10 | Dispersant 5 | 70 | 30 | 150 | 34500 | PGMEA | Butylacetate | 70/30 | Included | 230000 | 199 | A | A | A | 2 |
| Example 11 | Dispersant 1 | 70 | 30 | 120 | 31000 | PGMEA | Butyl acetate | 95/5 | Included | 230000 | 50 | A | A | A | 0 |
| Example 12 | Dispersant I | 70 | 30 | 120 | 31000 | PGMEA | Butyl acetate | 50/50 | Included | 230000 | 120 | A | A | A | 1 |
| Example 13 | Dispersant 1 | 70 | 30 | 120 | 31000 | PGMEA | Butyl acetate | 75/25 | Included | 230000 | 130 | B | B | A | 3 |
| Example 14 | Dispersant 1 | 70 | 30 | 120 | 31000 | PGMEA | Butyl acetate | 0/100 | Included | 230000 | 115 | A | A | A | 0 |
| Example 15 | Dispersant 1 | 70 | 30 | 120 | 31000 | PGMEA | Butyl acetate | 60/40 | Included | 230000 | 110 | A | A | A | 0 |
| Example 16 | Dispersant 1 | 70 | 30 | 120 | 31000 | PGMEA | Butylacetate | 60/40 | Included | 230000 | 106 | A | A | A | 1 |
| Example 17 | Dispersant 1 | 70 | 30 | 120 | 31000 | PGMEA | Butyl acetate | 60/40 | Included | 230000 | 94 | A | A | A | 0 |

(continued)

| | Dispersant | Composition ratio | | Acid value (mgKOH/g) | Mw | Solvent) 1 | Solvent 2 | Mass ratio [solvent 1/solvent 2] | First dispersion process | Shear rate (1/s) | Evaluation | | | | |
|---|---|---|---|---|---|---|---|---|---|---|---|---|---|---|---|
| | | X (%by mass) | Y (% by mass) | | | | | | | | The number of coarse particles (particles/ μL) | Precipitation property | | Temporal stability of the composition | Coated surface abnormality (the number) |
| | | | | | | | | | | | | Room temperature | -5°C | | |
| Comparative Example 1 | Dispersant 1 | 70 | 30 | 120 | 31000 | PGMEA | - | 100/0 | Included | 230000 | 135 | A | A | A | 24 |
| Comparative Example 2 | Dispersant 2 | 70 | 30 | 115 | 31000 | PGMEA | - | 100/0 | Included | 230000 | 134 | A | A | A | 31 |
| Comparative Example 3 | Dispersant 3 | 70 | 30 | 126 | 31000 | PGMEA | - | 100/0 | Included | 230000 | 146 | A | A | A | 26 |
| Comparative Example 4 | Dispersant 4 | 70 | 30 | 100 | 31000 | PGMEA | - | 100/0 | Included | 230000 | 164 | A | A | A | 27 |
| Comparative Example 5 | Dispersant 1 | 70 | 30 | 120 | 31000 | PGMEA | Butyl acetate | 60/40 | Not included | - | 8432 | A | A | A | 654 |

*Description of Table 1*

The "mass ratio [solvent 1/solvent 2]" column shows the mass ratio [solvent 1/lsolvent 2] in the mixed liquid to be treated in the first dispersion process.
"PGMEA" is propylene glycol monomethyl ether acetate.
"PGME" is propylene glycol monoethyl ether.
"EEP" is 3-ethoxyethylpropionate.

As shown in Table 1, the precipitation of titanium black was suppressed, the storage stability with the passage of time was excellent, and the occurrence of coated surface abnormalities (i.e., leakage in light shielding) was suppressed in Examples of the invention.
Therefore, a light-shielding color filter with little leakage in light shielding may be produced by subjecting the light shielding film of the invention to pattern exposure and developing the light shielding film after the exposure to form a pattern. Further, a solid-state image sensor that has little noise and is excellent in color reproducibility may be produced using a substrate for a solid-state image sensor, in which a light-sensitive element such as a photodiode is formed, as a support in place of silicon wafers.

## Claims

1. A method of producing a dispersion composition comprising:

    a first dispersion process of producing a dispersion liquid by subjecting a mixed liquid comprising titanium black, a dispersant and propylene glycol monomethyl ether acetate to a dispersion treatment without using a medium such as beads, sands or balls; and
    a second dispersion process of further subjecting the dispersion liquid obtained by the first dispersion treatment to a dispersion treatment using a medium such as beads, sands or balls,
    **characterized in that** the mixed liquid in the first dispersion process further comprises at least one solvent selected from the group consisting of butyl acetate, 2-heptanone, ethyl-3-ethoxypropionate, cyclohexanone, and propylene glycol monomethyl ether, wherein the content of the solvent in the mixed liquid is 5 % by mass or more relative to the total content of the propylene glycol monomethyl ether acetate and the solvent.

2. The method of producing a dispersion composition of claim 1, wherein the dispersant comprises a graft copolymer having a graft chain in which the total number of atoms other than hydrogen atoms is from 40 to 10,000.

3. The method of producing a dispersion composition of claim 2, wherein the graft copolymer comprises a structural unit represented by at least one of the following Formulae (1) to (5):

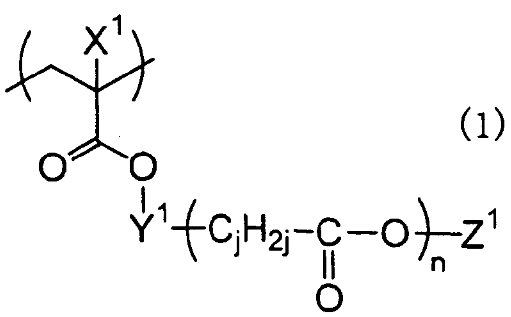
(1)

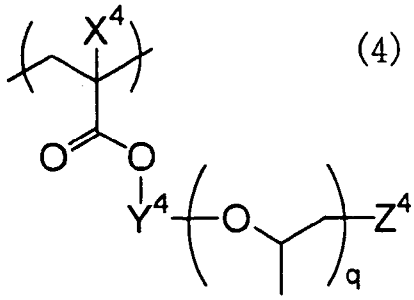
(4)

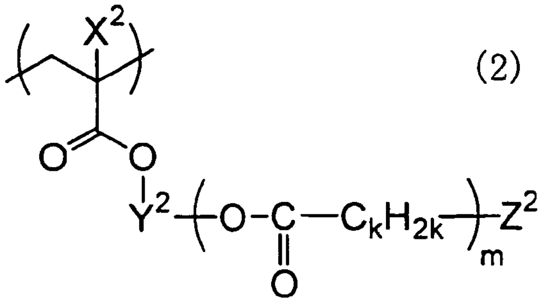

(2)

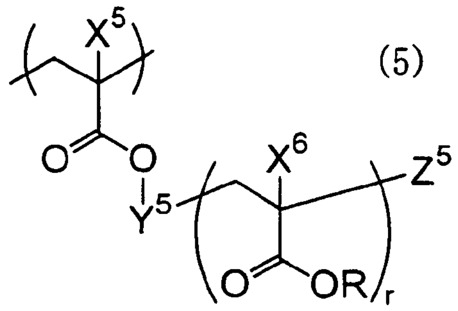

(5)

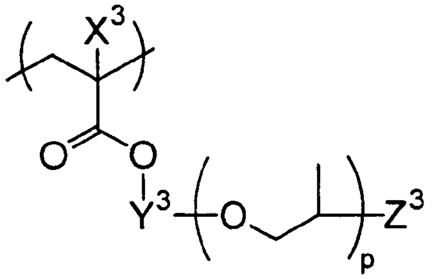

(3)

wherein, in Formulae (1) to (5), $X^1$, $X^2$, $X^3$, $X^4$, $X^5$, and $X^6$ each independently represents a hydrogen atom or a monovalent organic group; $Y^1$, $Y^2$, $Y^3$, $Y^4$, and $Y^5$ each independently represents a divalent linking group; $Z^1$, $Z^2$, $Z^3$, $Z^4$, and $Z^5$ each independently represents a monovalent organic group; R represents a hydrogen atom or a monovalent organic group, wherein two or more R's having different structures may be included in the graft copolymer; n, m, p, q, and r each represent an integer from 1 to 500; and j and k each represent an integer of from 2 to 8.

**4.** The method of producing a dispersion composition of claim 2 or 3, wherein the graft copolymer comprises a structural unit represented by at least one of Formulae (1) to (5) in a range of from 10% to 90% by mass relative to the total mass of the graft copolymer.

**5.** The method of producing a dispersion composition of any one of claims 1 to 4, wherein the second dispersion process comprises:

subjecting the dispersion liquid obtained by the first dispersion process to a dispersion treatment until the change in volume average particle diameter of the titanium black becomes 10 nm/pass or less and adding a dispersant to the resulting dispersion liquid,
to which a further dispersion treatment is then performed.

**6.** A dispersion composition, obtainable by the method of producing a dispersion composition of any one of claims 1 to 5.

**7.** A method of producing a photosensitive resin composition for a light-shielding color filter including titanium black, a dispersant, a resin, a polymerizable compound, a photopolymerization initiator, propylene glycol monomethyl ether acetate, and at least one solvent selected from the group consisting of butyl acetate, 2-heptanone, ethyl 3-ethoxypropionate, cyclohexanone, and propylene glycol monomethyl ether, the method comprising a first dispersion process and a second dispersion process as defined in any of claims 1 to 5.

**8.** A photosensitive resin composition for a light-shielding color filter, which is obtainable by the method of producing a photosensitive resin composition for a light-shielding color filter of claim 7.

**9.** A use of the photosensitive resin composition of claim 8 for producing a color filter for a solid-state image sensor.

**10.** A method of producing a light-shielding color filter, the method comprising:

applying the photosensitive resin composition for a light-shielding color filter of claim 8 to a support to form a photosensitive layer;

subjecting the photosensitive layer to pattern exposure; and
developing the photosensitive layer after the exposure to form a colored pattern.

11. A light-shielding color filter, which is obtainable by the method of producing a light-shielding color filter of claim 10.

12. A solid-state image sensor comprising the light-shielding color filter of claim 11.

## Patentansprüche

1. Verfahren zum Herstellen einer Dispersionszusammensetzung, umfassend:

einen ersten Dispersionsprozess zum Herstellen einer Dispersionsflüssigkeit, in dem eine gemischte Flüssigkeit, die Titanschwarz, ein Dispergiermittel und Propylenglykolmonomethyletheracetat umfasst, einer Dispersionsbehandlung unterzogen wird ohne ein Medium, wie z.B. Kügelchen, Partikel oder Kugeln zu verwenden; und
einen zweiten Dispersionsprozess, in dem die Dispersionsflüssigkeit, die durch die erste Dispersionsbehandlung erhalten wurde, ferner einer Dispersionsbehandlung unterzogen wird, worin ein Medium, wie z.B. Kügelchen, Partikel oder Kugeln, verwendet wird,
**dadurch gekennzeichnet, dass** die gemischte Flüssigkeit in dem ersten Dispersionsprozess ferner mindestens ein Lösungsmittel umfasst, ausgewählt aus der Gruppe bestehend aus Butylacetat, 2-Heptanon, Ethyl-3-ethoxypropionat, Cyclohexanon und Propylenglykolmonomethylether, worin der Gehalt des Lösungsmittels in der gemischten Flüssigkeit 5 Masse% oder mehr beträgt, relativ zum Gesamtgehalt von Propylenglykolmonomethyletheracetat und dem Lösungsmittel.

2. Verfahren zum Herstellen einer
Dispersionszusammensetzung gemäß Anspruch 1, worin das Dispergiermittel ein Pfropfcopolymer umfasst, das eine Pfropfkette aufweist, worin die Gesamtanzahl von Atomen außer Wasserstoffatomen 40 bis 10.000 beträgt.

3. Verfahren zum Herstellen einer
Dispersionszusammensetzung gemäß Anspruch 2, worin das Pfropfcopolymer eine Struktureinheit umfasst, die durch mindestens eine der folgenden Formeln (1) bis (5) dargestellt ist:

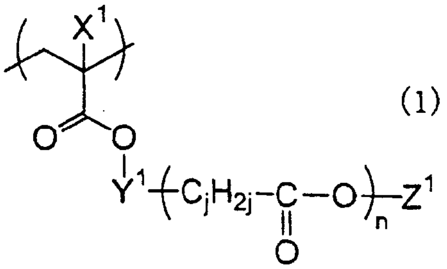
(1)

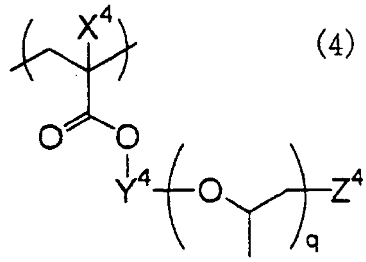
(4)

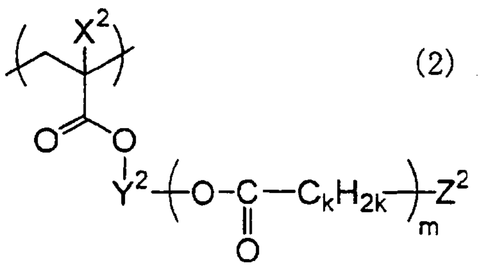
(2)

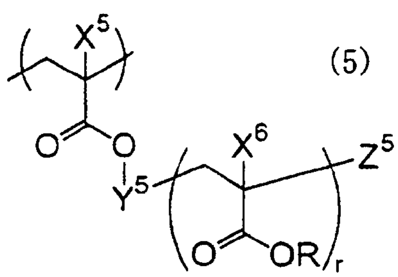
(5)

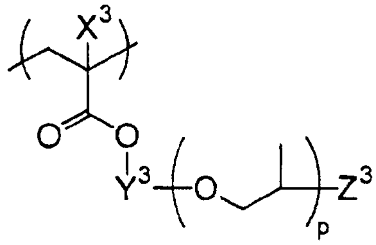
(3)

worin in den Formeln (1) bis (5) $X^1$, $X^2$ , $X^3$, $X^4$, $X^5$ und $X^6$ jeweils unabhängig voneinander ein Wasserstoffatom oder eine monovalente organische Gruppe darstellen; $Y^1$, $Y^2$, $Y^3$, $Y^4$ und $Y^5$ jeweils unabhängig voneinander eine divalente Verknüpfungsgruppe darstellen; $Z^1$, $Z^2$, $Z^3$, $Z^4$ und $Z^5$ jeweils unabhängig voneinander eine monovalente organische Gruppe darstellen; R ein Wasserstoffatom oder eine monovalente organische Gruppe darstellt, worin zwei oder mehr R mit verschiedenen Strukturen in dem Pfropfcopolymer enthalten sein können; n, m, p, q und r jeweils eine ganze Zahl von 1 bis 500 darstellen; und j und k jeweils eine ganze Zahl von 2 bis 8 darstellen.

**4.** Verfahren zum Herstellen einer Dispersionszusammensetzung gemäß Anspruch 2 oder 3, worin das Pfropfcopolymer eine Struktureinheit, die durch mindestens eine der Formeln (1) bis (5) dargestellt wird, in einer Menge von 10 bis 90 Masse% umfasst, relativ zur Gesamtmasse des Pfropfcopolymers.

**5.** Verfahren zum Herstellen einer Dispersionszusammensetzung gemäß irgeneinem der Ansprüche 1 bis 4, worin der zweite Dispersionsprozess umfasst:

Unterziehen der Dispersionsflüssigkeit, die in dem ersten Dispersionsprozess erhalten wurde, unter eine Dispersionsbehandlung, bis die Veränderung des volumengemittelten Partikeldurchmessers des Titanschwarz 10 nm/Durchgang oder weniger beträgt, und Zugeben eines Dispergiermittels zu der resultierenden Dispersionsflüssigkeit, mit der dann eine weitere Dispersionsbehandlung durchgeführt wird.

**6.** Dispersionszusammensetzung, erhältlich durch das Verfahren zum Herstellen einer Dispersionszusammensetzung gemäß irgendeinem der Ansprüche 1 bis 5.

**7.** Verfahren zum Herstellen einer fotoempfindlichen Harzzusammensetzung für einen lichtabschirmenden Farbfilter, umfassend Titanschwarz, ein Dispergiermittel, ein Harz, eine polymerisierbare Verbindung, einen Fotopolymerisationsinitiator, Propylenglykolmonomethyletheracetat und mindestens ein Lösungsmittel, ausgewählt aus der Gruppe bestehend aus Butylacetat, 2-Heptanon, Ethyl-3-ethoxypropionat, Cyclohexanon und Propylenglykolmonomethylether, wobei das Verfahren einen ersten Dispersionsprozess und einen zweiten Dispersionsprozess, wie in irgendeinem der Ansprüche 1 bis 5 definiert, umfasst.

**8.** Fotoempfindliche Harzzusammensetzung für einen lichtabschirmenden Farbfilter, die erhältlich ist durch das Verfahren zum Herstellen einer fotoempfindlichen Harzzusammensetzung für einen lichtabschirmenden Farbfilter gemäß Anspruch 7.

**9.** Verwendung der fotoempfindlichen Harzzusammensetzung gemäß Anspruch 8 zum Herstellen eines Farbfilters für einen Festkörper-Bildsensor.

**10.** Verfahren zum Herstellen eines lichtabschirmenden Farbfilters, wobei das Verfahren umfasst:

Auftragen der fotoempfindlichen Harzzusammensetzung für einen lichtabschirmenden Farbfilter gemäß Anspruch 8 auf einen Träger, um eine fotoempfindliche Schicht zu bilden;
Unterziehen der fotoempfindlichen Schicht unter eine Musterbelichtung; und
Entwickeln der fotoempfindlichen Schicht nach der Belichtung, um ein gefärbtes Muster zu bilden.

**11.** Lichtabschirmender Farbfilter, erhältlich durch das Verfahren zum Herstellen eines lichtabschirmenden Farbfilters gemäß Anspruch 10.

**12.** Festkörper-Bildsensor, umfassend den lichtabschirmenden Farbfilter gemäß Anspruch 11.

## Revendications

**1.** Procédé de production d'une composition de dispersion comprenant :

un premier procédé de dispersion pour la production d'un liquide de dispersion soumettant un liquide mixte comprenant du noir de titane, un dispersant et de l'acétate de monométhyléther de propylèneglycol à un traitement de dispersion sans utiliser un milieu, tel que des billes, des sables ou des balles ; et
un second procédé de dispersion soumettant en plus le liquide de dispersion obtenu par le premier traitement de dispersion à un traitement de dispersion utilisant un milieu, tel que des billes, des sables ou des balles,
**caractérisé en ce que** le liquide mixte dans le premier procédé de dispersion comprend de plus au moins un solvant choisi dans le groupe constitué de l'acétate de butyle, de la 2-heptanone, du 3-éthoxypropionate d'éthyle, de la cyclohexanone et du monométhyléther de propylèneglycol, dans lequel la teneur du solvant dans le liquide mixte est de 5 % en masse ou supérieure par rapport à la teneur totale de l'acétate de monométhyléther de propylèneglycol et du solvant.

**2.** Procédé de production d'une composition de dispersion selon la revendication 1, dans lequel le dispersant comprend un copolymère greffé présentant une chaîne greffée dans laquelle le nombre total d'atomes différents des atomes d'hydrogène est de 40 à 10 000.

**3.** Procédé de production d'une composition de dispersion selon la revendication 2, dans lequel le copolymère greffé comprend une unité structurelle représentée par au moins l'une des formules (1) à (5) suivantes :

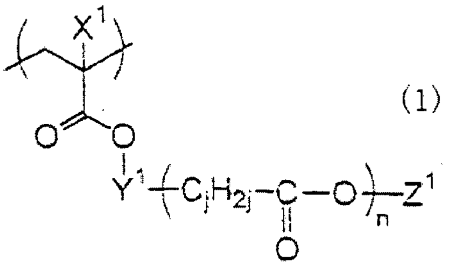
(1)

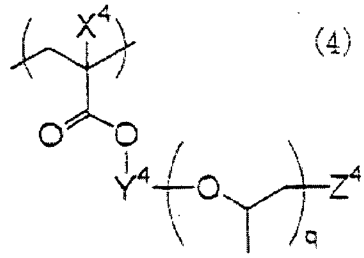
(4)

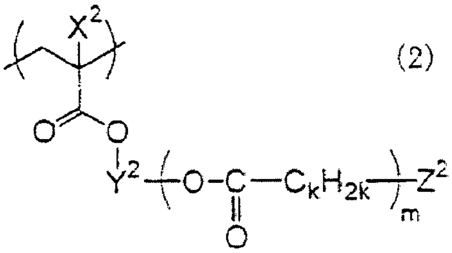
(2)

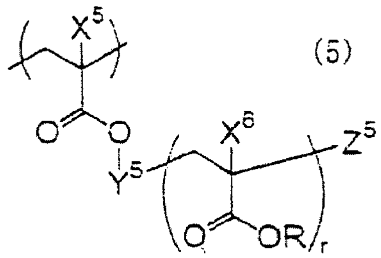
(5)

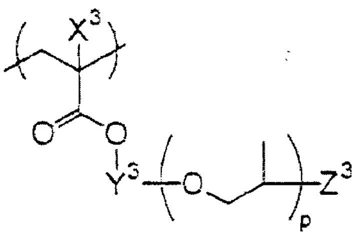
(3)

où, dans les formules (1) à (5), $X^1$, $X^2$, $X^3$, $X^4$, $X^5$ et $X^6$ représentent chacun indépendamment un atome d'hydrogène ou un groupe organique monovalent ; $Y^1$, $Y^2$, $Y^3$, $Y^4$, et $Y^5$ représentent chacun indépendamment un groupe de liaison divalent ; $Z^1$, $Z^2$, $Z^3$, $Z^4$, et $Z^5$ représentent chacun indépendamment un groupe organique monovalent ; R

représente un atome d'hydrogène ou un groupe organique monovalent, où deux ou plusieurs R présentant des structures différentes peuvent être inclus dans le copolymère greffé ; n, m, p, q, et r représentent chacun un nombre entier de 1 à 500 ; et j et k représentent chacun un nombre entier de 2 à 8.

**4.** Procédé de production d'une composition de dispersion selon la revendication 2 ou 3, dans lequel le copolymère greffé comprend une unité structurelle représentée par au moins une des formules (1) à (5) dans un intervalle de 10 % à 90 % en masse par rapport à la masse totale du copolymère greffé.

**5.** Procédé de production d'une composition de dispersion selon l'une quelconque des revendications 1 à 4, dans lequel le second procédé de dispersion comprend :

un traitement de dispersion du liquide de dispersion obtenu par le premier procédé de dispersion jusqu'à ce que la modification du diamètre de particule moyen en volume du noir de titane soit de 10 nm/passage ou inférieur et une addition d'un dispersant au liquide de dispersion résultant, sur lequel un autre traitement de dispersion est ensuite réalisé.

**6.** Composition de dispersion pouvant être obtenue par le procédé de production d'une composition de dispersion selon l'une quelconque des revendications 1 à 5.

**7.** Procédé de production d'une composition de résine photosensible pour un filtre de couleur faisant écran à la lumière comprenant du noir de titane, un dispersant, une résine, un composé polymérisable, un initiateur de photopolymérisation, de l'acétate de monométhyléther de propylèneglycol, et au moins un solvant choisi dans le groupe constitué de l'acétate de butyle, de la 2-heptanone, du 3-éthoxypropionate d'éthyle, de la cyclohexanone, et du monométhyléther de propylèneglycol, le procédé comprenant un premier procédé de dispersion et un second procédé de dispersion selon l'une quelconque des revendications 1 à 5.

**8.** Composition de résine photosensible pour un filtre de couleur faisant écran à la lumière, laquelle peut être obtenue par le procédé de production d'une composition de résine photosensible pour un filtre de couleur faisant écran à la lumière selon la revendication 7.

**9.** Utilisation de la composition de résine photosensible selon la revendication 8 pour la production d'un filtre de couleur destiné à un capteur d'image à semi-conducteurs.

**10.** Procédé de production d'un filtre de couleur faisant écran à la lumière, le procédé comprenant :

l'application de la composition de résine photosensible pour un filtre de couleur faisant écran à la lumière selon la revendication 8 à un support pour former une couche photosensible ;
l'exposition de la couche photosensible à un motif ; et
le développement de la couche photosensible après l'exposition pour former un motif coloré.

**11.** Filtre de couleur faisant écran à la lumière, lequel peut être obtenu par le procédé de production d'un filtre de couleur faisant écran à la lumière selon la revendication 10.

**12.** Capteur d'image à semi-conducteurs comprenant le filtre de couleur faisant écran à la lumière selon la revendication 11.

FIG.1

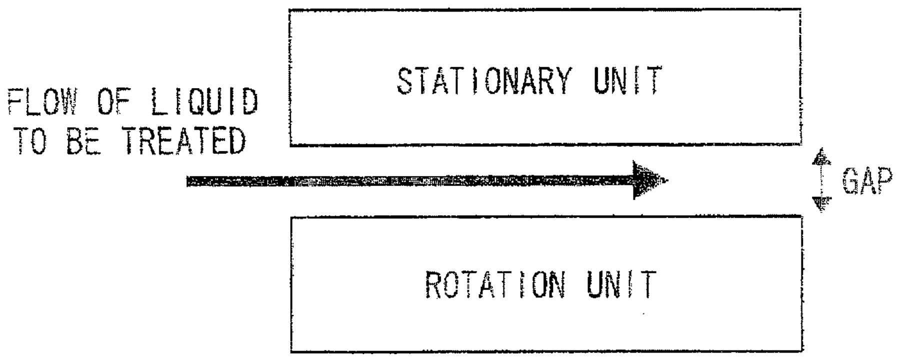
STATIONARY UNIT
FLOW OF LIQUID
TO BE TREATED
GAP
ROTATION UNIT

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 3724269 B
- WO 2005037926 A
- JP 2006182627 A
- JP 2006206891 A
- JP 2006209102 A
- JP 2007115921 A
- EP 2103966 A2
- JP 2007302836 A
- JP 49005432 A
- JP 57205322 A
- JP 60065069 A
- JP 61201610 A
- JP 59044615 A
- JP 54034327 B
- JP 58012577 B
- JP 54025957 B
- JP 54092723 A
- JP 59053836 A
- JP 59071048 A
- JP 2000187322 A
- JP 2002062698 A
- JP 2001242612 A
- JP 7012004 B
- JP 7120041 B
- JP 7120042 B
- JP 8012424 B
- JP 63287944 A
- JP 63287947 A
- JP 1271741 A
- JP 2002107918 A
- EP 993966 A
- EP 1204000 A
- JP 2001318463 A
- JP 51047334 A
- JP 57196231 A
- JP 59005240 A
- JP 59005241 A
- JP 2226149 A
- JP 1165613 A
- JP 54021726 B
- JP 48041708 B
- JP 2000080068 A
- WO 02100903 A1
- JP 2001233842 A